(19) **Europäisches Patentamt**
**European Patent Office**
**Office européen des brevets**

(11) **EP 4 451 575 B1**

(12) **EUROPEAN PATENT SPECIFICATION**

(45) Date of publication and mention
of the grant of the patent:
**27.05.2026 Bulletin 2026/22**

(21) Application number: **21967577.4**

(22) Date of filing: **14.12.2021**

(51) International Patent Classification (IPC):
*G06N 3/045* (2023.01)    *H03M 7/30* (2006.01)
*H04B 7/06* (2006.01)    *G06N 3/02* (2006.01)

(52) Cooperative Patent Classification (CPC):
**H04B 7/06; G06N 3/02; G06N 3/045; H03M 7/70**

(86) International application number:
**PCT/CN2021/138032**

(87) International publication number:
**WO 2023/108437 (22.06.2023 Gazette 2023/25)**

(54) **CHANNEL STATE INFORMATION (CSI) COMPRESSION FEEDBACK METHOD AND APPARATUS**

VERFAHREN UND VORRICHTUNG FÜR KOMPRESSIONSFEEDBACK VON KANALZUSTANDSINFORMATIONEN (CSI)

PROCÉDÉ ET APPAREIL DE RÉTROACTION DE COMPRESSION D'INFORMATIONS D'ÉTAT DE CANAL (CSI)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**23.10.2024 Bulletin 2024/43**

(73) Proprietor: **Beijing Xiaomi Mobile Software Co., Ltd.**
**Beijing 100085 (CN)**

(72) Inventors:
• **CHEN, Dong**
**Beijing 100085 (CN)**
• **CHI, Liangang**
**Beijing 100085 (CN)**

(74) Representative: **Gunzelmann, Rainer**
**Wuesthoff & Wuesthoff**
**Patentanwälte und Rechtsanwalt PartG mbB**
**Schweigerstraße 2**
**81541 München (DE)**

(56) References cited:
**WO-A1-2021/212327    CN-A- 110 350 958**
**CN-A- 113 472 412**

• XU YANG ET AL: "Transformer Empowered CSI Feedback for Massive MIMO Systems", 2021 30TH WIRELESS AND OPTICAL COMMUNICATIONS CONFERENCE (WOCC), IEEE, 7 October 2021 (2021-10-07), pages 157 - 161, XP034022674, DOI: 10.1109/WOCC53213.2021.9602863
• LU CHAO ET AL: "MIMO Channel Information Feedback Using Deep Recurrent Network", IEEE COMMUNICATIONS LETTERS, IEEE SERVICE CENTER, PISCATAWAY, NJ, US, vol. 23, no. 1, 1 January 2019 (2019-01-01), pages 188 - 191, XP011696277, ISSN: 1089-7798, [retrieved on 20190107], DOI: 10.1109/LCOMM.2018.2882829
• LI QI ET AL: "A Novel CSI Feedback Approach for Massive MIMO Using LSTM-Attention CNN", IEEE ACCESS, IEEE, USA, vol. 8, 3 January 2020 (2020-01-03), pages 7295 - 7302, XP011765536, DOI: 10.1109/ACCESS.2020.2963896

**Description**

TECHNICAL FIELD

The disclosure relates to a field of communication technology, more particularly, to a channel state information (CSI) compression feedback method and a CSI compression feedback apparatus.

BACKGROUND

With the development of the 5th generation wireless communication networks, massive Multiple-Input Multiple-Output (mMIMO) has become a key technology. By configuring a large number of antennas, the mMIMO not only greatly improves a channel capacity under limited spectrum resources, but also has a strong anti-interference capability. In order to better use the mMIMO technology, a transmitter may obtain channel state information (CSI). In a system, a terminal estimates CSI of a downlink channel and then feeds back the CSI to a network device through a feedback link with a fixed bandwidth.

The multi-antenna nature of the mMIMO causes an overhead of CSI feedback to be huge, but there is lack of means for efficiently and accurately feeding back the CSI in the related art.

The article from Yang Xu et al " Transformer Empowered CSI Feedback for Massive MIMO Systems", in the 30th Wireless and optical communications conference, 2021, discloses a novel CSI feedback scheme called CsiTransformer that leverages transformer models for efficient compression and reconstruction of channel state information in massive MIMO systems, achieving better performance than conventional methods at various compression rates. The article from Chao Lu et al " MIMO Channel Information Feedback Using Deep Recurrent Network" in the IEEE Communication letters, 2019, discloses a deep learning approach using LSTM networks for CSI feedback in MIMO systems, which captures temporal channel correlations and reduces feedback overhead while maintaining reconstruction accuracy compared to traditional methods. The article from Qi Li et al " A Novel CSI Feedback Approach for Massive MIMO Using LSTM-Attention CNN" in IEEE access, 2020, discloses a hybrid LSTM-Attention CNN framework for CSI feedback that combines LSTM's temporal correlation learning with attention mechanism's feature weighting capability, achieving higher feedback accuracy with lower complexity than conventional algorithms.

SUMMARY

The invention is defined by the appended claims. Embodiments of the disclosure provide a channel state information (CSI) compression feedback method and a CSI compression feedback apparatus, which can be applied to various kinds of communication systems, such as, a 5th generation (5G) mobile communication system, a 5G new radio (NR) system, or other future new mobile communication systems. In the method, a terminal compresses a temporal CSI image $H_c$ corresponding to an estimated CSI image H to generate a feature codeword, and then feeds back the temporal CSI image $H_c$ to a network device via the feature codeword, which can reduce channel resources occupied for feeding back the CSI image, thereby saving resources and improving the accuracy of feeding back the CSI image.

According to a first aspect of embodiments of the disclosure, a CSI compression feedback method, performed by a terminal, is provided. The method includes:

> obtaining an estimated CSI image H of a network device, and generating a temporal CSI image $H_c$ according to the estimated CSI image H;
> compressing the temporal CSI image $H_c$ to generate a feature codeword; and
> sending the feature codeword to the network device.

Furthermore, compressing the temporal CSI image $H_c$ to generate the feature codeword includes:

> generating a temporal self-information image $H_e$ by inputting the temporal CSI image $H_c$ into a self-information domain transformer, in which a time dimension of both the temporal CSI image $H_c$ and the temporal self-information image $H_e$ is T;
> generating a structural feature matrix and a temporal correlation matrix by inputting the temporal self-information image $H_e$ into a temporal feature coupling encoder for feature extraction; and
> generating the feature codeword according to the structural feature matrix and the temporal correlation matrix.

Optionally, generating the temporal self-information image $H_e$ by inputting the temporal CSI image $H_c$ into the self-information domain transformer includes:

obtaining a first temporal feature image F by inputting the temporal CSI image $H_c$ into a three-dimensional convolutional feature extraction network for feature extraction, in which a convolution kernel specification of the three-dimensional convolutional network is $f \times t \times n \times n$, $f$ represents a number of features to be extracted, $t$ represents a convolution depth in a time dimension, and n represents a length and a width of a convolution window;

generating a first index matrix M according to the temporal CSI image $H_c$; and

obtaining the temporal self-information image $H_e$ according to the first temporal feature image F and the first index matrix M.

Optionally, generating the first index matrix M according to the temporal CSI image $H_c$ includes:

generating self-information of an area to be estimated in the temporal CSI image $H_c$ as a self-information image by inputting the temporal CSI image $H_c$ into a self-information module; and

obtaining the first index matrix M by inputting the self-information image into an index matrix module for mapping.

Optionally, generating the self-information of the area to be estimated in the temporal CSI image $H_c$ as the self-information image by inputting the temporal CSI image $H_c$ into the self-information module includes:

obtaining split images $H_{c,i}$ at a plurality of time points by splitting the temporal CSI image $H_c$ according to a time sequence; and

dividing the split images into a plurality of areas to be estimated $p_j$, obtaining self-information estimation values $\hat{I}_j$ corresponding to the plurality of areas to be estimated, and generating a self-information image $I_{c,i}$ according to the self-information estimation values $\hat{I}_j$.

Optionally, the index matrix module includes a mapping network and a judger, and obtaining the first index matrix M by inputting the self-information image into the index matrix module for mapping includes:

obtaining a first information feature image $D_{c,i}$ by inputting the self-information image into the mapping network for feature extraction, in which the mapping network is a two-dimensional convolutional neural network;

obtaining a second index matrix $M_i$ by inputting the first information feature image $D_{c,i}$ into the judger for binarization; and

obtaining the first index matrix M by splicing the second index matrix $M_i$.

Optionally, the mapping network includes a two-dimensional convolutional layer, a two-dimensional normalization layer and an activation layer, and inputting the self-information image into the mapping network for feature extraction includes:

obtaining a first feature image by inputting the self-information image into the two-dimensional convolutional layer for feature extraction;

obtaining a second feature image by inputting the first feature image into the two-dimensional normalization layer to normalize pixel values in the first feature image; and

obtaining the first information feature image $D_{c,i}$ by inputting the second feature image into the activation function layer for nonlinear mapping.

Optionally, obtaining the first index matrix M by splicing the second index matrix $M_i$ includes:

obtaining the first index matrix M by splicing the second index matrix $M_i$ in an order of time sequence.

Optionally, obtaining the temporal self-information image $H_e$ according to the first temporal feature image F and the first index matrix M, includes:

obtaining a second information feature image by multiplying the first temporal feature image F and the first index matrix M; and

generating the temporal self-information image $H_e$ by inputting the second information feature image into a dimension restoration network for dimension restoration.

Optionally, the temporal feature coupling encoder includes a one-dimensional time-space compression network and a coupling long short term memory network (LSTM).

Optionally, generating the structural feature matrix and the temporal correlation matrix by inputting the temporal self-information image $H_e$ into the temporal feature coupling encoder for feature extraction includes:

obtaining the structural feature matrix by inputting the temporal self-information image $H_e$ subjected to dimension

transformation into the one-dimensional time-space compression network for one-dimensional time-space compression, in which a convolution kernel specification of the one-dimensional time-space compression network is $S \times 2N_cN_t \times m$, $2N_cN_t$ represents a length of a convolution window, m represents a width of the convolution window, S represents a target dimension, and a dimension of the structural feature matrix is $T \times S$.

Optionally, generating the structural feature matrix and the temporal correlation matrix by inputting the temporal self-information image $H_e$ into the temporal feature coupling encoder for feature extraction includes:

obtaining the structural feature matrix by inputting the temporal self-information image $H_e$ subjected to dimension transformation into a coupling LSTM for feature extraction, in which a dimension of the temporal correlation matrix is $T \times S$; and
coupling the structural feature matrix and the temporal correlation matrix to generate the feature codeword.

Optionally, the method further includes:

obtaining a training temporal self-information image $H_e$ by inputting a training temporal CSI image $H_c$ into a self-information domain transformer; and
obtaining a training feature codeword by inputting the training temporal self-information image $H_e$ into the temporal feature coupling encoder.

Optionally, the method further includes:
sending training data to the network device, in which the training data includes the training feature codeword, a time-sequence length of a temporal self-information image $H_e$, a dimension of the training feature codeword, and a training temporal CSI image $H_c$.

According to a second aspect of embodiments of the disclosure, a CSI decompression feedback method, performed by a network device, is provided. The method includes:

receiving a feature codeword sent by a terminal;
restoring the feature codeword to obtain a restored temporal CSI image $H_c$; and
obtaining an estimated CSI image $\hat{H}$ of the terminal according to the restored temporal CSI image $\hat{H}_c$.

The network device decompresses the feature codeword compressed by the terminal to obtain the restored estimated CSI image $\hat{H}$, which can reduce channel resources occupied for feeding back the CSI image, thereby saving resources and improving the accuracy of feeding back the CSI image.

Furthermore, restoring the feature codeword includes:

obtaining a restored temporal self-information image $\hat{H}_e$ by inputting the feature codeword into the decoupling module for decoupling; and
obtaining the restored temporal CSI image $\hat{H}_c$ by inputting the restored temporal self-information image $\hat{H}_e$ into the restoration convolutional neural network for restoration.

Optionally, the decoupling module includes a one-dimensional time-space decompression network and a decoupling LSTM, obtaining the restored temporal self-information image by inputting the feature codeword into the decoupling module for decoupling includes:

obtaining a restored structural feature matrix by inputting the feature codeword into the one-dimensional time-space decompression network for decompression;
obtaining a restored temporal correlation matrix by inputting the feature codeword into the decoupling LSTM for decoupling; and
obtaining the restored temporal self-information image $\hat{H}_e$ according to the restored structural feature matrix and the restored temporal correlation matrix.

Optionally, a convolution kernel specification of the one-dimensional time-space decompression network is $2N_cN_t \times S \times m$, T represents a number of rows in the restored temporal correlation matrix, and $2N_cN_t$ represents a number of columns in the restored temporal correlation matrix.

Optionally, obtaining the restored temporal self-information image $\hat{H}_e$ according to the restored structural feature matrix and the restored temporal correlation matrix, includes:
adding the restored structural feature matrix and the restored temporal correlation matrix point by point and performing dimension transformation to obtain the restored temporal self-information image $\hat{H}_e$.

Optionally, the restored convolution neural network includes a first convolutional layer, a second convolutional layer, a third convolutional layer, a fourth convolutional layer, a fifth convolutional layer, a sixth convolutional layer, and a seventh convolutional layer, in which a convolution kernel specification of the first convolutional layer and the fourth convolutional layer is $l_1 \times t \times n \times n$, a convolution kernel specification of the second convolutional layer and the fifth convolutional layer is $l_2 \times t \times n \times n$, and a convolution kernel specification of the third convolutional layer, the sixth convolutional layer and the seventh convolutional layer is $2 \times t \times n \times n$, $t$ represents a convolution depth in a time dimension, $l_1$, $l_2$ and 2 are numbers of extracted features, and n represents a length and a width of a convolution window.

Optionally, obtaining the restored temporal CSI image $\dot{H}_c$ by inputting the restored temporal self-information image $\dot{H}_e$ into the restoration convolutional neural network for restoration includes:

obtaining a first restored feature map by inputting the restored temporal self-information image $\dot{H}_e$ into the first convolutional layer for convolution, obtaining a second restored feature map by inputting the first restored feature map into the second convolutional layer, obtaining a third restored feature map by inputting the second restored feature map into the third convolutional layer, and obtaining a fourth restored feature map by adding the third restored feature map and the restored temporal self-information image $\dot{H}_e$;

obtaining a fifth restored feature map by inputting the fourth restored feature map into the fourth convolutional layer, obtaining a sixth restored feature map by inputting the fifth reduced feature map into the fifth convolutional layer, obtaining a seventh restored feature map by inputting the sixth restored feature map into the sixth convolutional layer, and obtaining an eighth restored feature map by adding the fourth restored feature map and the seventh restored feature map; and

obtaining the restored temporal CSI image $\dot{H}_c$ by inputting the eighth restored feature image into the seventh convolutional layer for normalization.

Optionally, the method includes:

receiving training data sent by the terminal, in which the training data includes a training feature codeword, a time-sequence length of a temporal self-information image $H_e$, a dimension of the training feature codeword, and a training temporal CSI image;

obtaining a restored temporal CSI image according to the training feature codeword; and

performing training according to the restored temporal CSI image and the training temporal CSI image.

Optionally, the method includes:

determining a number of structural units in a decoupling LSTM according to the time-sequence length of the temporal self-information image $H_e$; and

determining network parameters of a one-dimensional time-space decompression network according to the dimension of the training feature codeword.

Optionally, the method includes:

performing multiple rounds of training, in which an equation of a learning rate in the training is represented as:

$$\gamma = \gamma_{min} + \frac{1}{2}(\gamma_{max} + \gamma_{min})[1 + cos(\frac{t-T_w}{T'-T_w}\pi)],$$

where $\gamma$ represents a current learning rate, $\gamma_{max}$ represents a maximum learning rate, $\gamma_{min}$ represents a minimum learning rate, $t$ represents a current number of training rounds, $T_w$ represents a number of gradual learnings, $T'$ represents a number of overall training cycles.

Optionally, the method includes:

obtaining recommended network parameters for a decoupling module and a restored convolutional neural network, and updating the decoupling module and the restored convolutional neural network according to the recommended network parameters.

According to a third aspect of embodiments of the disclosure, a communication device is provided. The communication device has an ability to implement part or all of the functions of the terminal in the method described in the first aspect. For example, the communication device may have functions of some or all of embodiments of the disclosure, or may have a function of independently implementing any embodiment of the disclosure. The functions can be implemented by hardware, or can be implemented by executing corresponding software using the hardware. The hardware or software includes one or more units or modules corresponding to the above functions.

**In** an implementation, the communication device includes: a transceiver module and a processing module. The processing module is configured to support the communication device to perform corresponding functions in the above method. The transceiver module is configured to support communication between the communication device and other devices. The communication device may further include a storage module coupled to the transceiver module and the processing module, and the storage module is configured to store necessary computer programs and data for the communication device.

As an example, the processing module may be a processor. The transceiver module may be a transceiver or a communication interface. The storage module may be a memory.

In an implementation, the communication device includes:

an estimation module, configured to obtain an estimated CSI image H of a network device, and generate a temporal CSI image $H_c$ according to the estimated CSI image H;
a compressing module, configured to compress the temporal CSI image $H_c$ to generate a feature codeword; and
a sending module, configured to send the feature codeword to the network device.

According to a fourth aspect of embodiments of the disclosure, a communication device is provided. The communication device has an ability to implement part or all of the functions of the network device in the method described in the second aspect. For example, the communication device may have functions of some or all of embodiments of the disclosure, or may have a function of independently implementing any embodiment of the disclosure. The functions can be implemented by hardware, or can be implemented by executing corresponding software using the hardware. The hardware or software includes one or more units or modules corresponding to the above functions.

In an implementation, the communication device includes: a transceiver module and a processing module. The processing module is configured to support the communication device to perform corresponding functions in the above method. The transceiver module is configured to support communication between the communication device and other devices. The communication device may further include a storage module coupled to the transceiver module and the processing module, and the storage module is configured to store necessary computer programs and data for the communication device.

As an example, the processing module may be a processor. The transceiver module may be a transceiver or a communication interface. The storage module may be a memory.

In an implementation, the communication device includes:

a receiving module, configured to receive a feature codeword sent by a terminal;
a restoring module, configured to restore the feature codeword to obtain a restored temporal CSI image $H_c$; and
a channel obtaining module, configured to obtain a restored estimated CSI image $\hat{H}$ according to the restored temporal CSI image $\hat{H}_c$.

According to a fifth aspect of embodiments of the disclosure, a communicating device is provided. The communicating device includes: a processor. When the processor calls a computer program stored in a memory, the method described in the first aspect above is implemented.

According to a sixth aspect of embodiments of the disclosure, a communicating device is provided. The communicating device includes: a processor. When the processor calls a computer program stored in a memory, the method described in the second aspect above is implemented.

According to a seventh aspect of embodiments of the disclosure, a communication device is provided. The communication device includes: a processor and a memory having a computer program stored thereon. The processor executes the computer program stored in the memory, to cause the communication device to implement the method described in the first aspect above.

According to an eighth aspect of embodiments of the disclosure, a communication device is provided. The communication device includes: a processor and a memory having a computer program stored thereon. The processor executes the computer program stored in the memory, to cause the communication device to implement the method described in the second aspect above.

According to a ninth aspect of embodiments of the disclosure, a communication device is provided. The communication device includes: a processor and an interface circuit. The interface circuit is configured to receive code instructions and transmit them to the processor. The processor is configured to run the code instructions to cause the communication device to perform the method described in the first aspect above.

According to a tenth aspect of embodiments of the disclosure, a communication device is provided. The communication device includes: a processor and an interface circuit. The interface circuit is configured to receive code instructions and transmit them to the processor. The processor is configured to run the code instructions to cause the communication device to perform the method described in the second aspect above.

According to an eleventh aspect of embodiments of the disclosure, a CSI compression feedback system is provided. The system includes the communication device of the third aspect and the communication device of the fourth aspect; or the system includes the communication device of the fifth aspect and the communication device of the sixth aspect; or the system includes the communication device of the seventh aspect and the communication device of the eighth aspect; or the system includes the communication device of the ninth aspect and the communication device of the tenth aspect.

According to a twelfth aspect of embodiments of the disclosure, a computer-readable storage medium is provided. The computer-readable storage medium is configured to store instructions used by the above terminal. When the instructions are executed, the terminal is caused to implement the method of the first aspect.

According to a thirteenth aspect of embodiments of the disclosure, a computer-readable storage medium is provided. The computer-readable storage medium is configured to store instructions used by the above network device. When the instructions are executed, the network device is caused to implement the method of the second aspect.

According to a fourteenth aspect of embodiments of the disclosure, a computer program product including a computer program is provided. When the computer program is run by a computer, the computer is caused to implement the method of the first aspect.

According to a fifteenth aspect of embodiments of the disclosure, a computer program product including a computer program is provided. When the computer program is run by a computer, the computer is caused to implement the method of the second aspect.

According to a sixteenth aspect of embodiments of the disclosure, a chip system is provided. The chip system includes at least one processor and an interface, for supporting the terminal in realizing the functions involved in the first aspect, e.g., determining or processing at least one of data or information involved in the method described above. In a possible design, the chip system further includes a memory. The memory is configured to store necessary computer programs and data of the terminal. The chip system may consist of chips or may include a chip and other discrete devices.

According to a seventeenth aspect of embodiments of the disclosure, a chip system is provided. The chip system includes at least one processor and an interface for supporting the network device in realizing the functions involved in the second aspect, e.g., determining or processing at least one of data or information involved in the method described above. In a possible design, the chip system further includes a memory. The memory is configured to store necessary computer programs and data of the network device. The chip system may consist of chips or may include a chip and other discrete devices.

According to an eighteenth aspect of embodiments of the disclosure, a computer program is provided. When the computer program is running on a computer, the computer is caused to implement the method of the first aspect.

According to a nineteenth aspect of embodiments of the disclosure, a computer program is provided. When the computer program is running on a computer, the computer is caused to implement the method of the second aspect.

## BRIEF DESCRIPTION OF THE DRAWINGS

In order to clearly illustrate technical solutions of embodiments of the disclosure or background technologies, a description of drawings used in the embodiments or the background technologies is given below.

FIG. 1 is a schematic diagram of a communication system of an embodiment of the disclosure.

FIG. 2 is a flowchart of a channel state information (CSI) compression feedback method of an embodiment of the disclosure.

FIG. 3 is a flowchart of a CSI compression feedback method of an embodiment of the disclosure.

FIG. 4 is a flowchart of a CSI compression feedback method of an embodiment of the disclosure.

FIG. 5 is a flowchart of a CSI compression feedback method of an embodiment of the disclosure.

FIG. 6 is a flowchart of a CSI compression feedback method of an embodiment of the disclosure.

FIG. 7 is a flowchart of a CSI compression feedback method of an embodiment of the disclosure.

FIG. 8 is a flowchart of a CSI compression feedback method of an embodiment of the disclosure.

FIG. 9 is a flowchart of a CSI compression feedback method of an embodiment of the disclosure.

FIG. 10 is a flowchart of a CSI compression feedback method of an embodiment of the disclosure.

FIG. 11 is a flowchart of a CSI compression feedback method of an embodiment of the disclosure.

FIG. 12 is a flowchart of a CSI compression feedback method of an embodiment of the disclosure.

FIG. 13 is a flowchart of a CSI compression feedback method of an embodiment of the disclosure.

FIG. 14 is a flowchart of a CSI compression feedback method of an embodiment of the disclosure.

FIG. 15 is a flowchart of a CSI compression feedback method of an embodiment of the disclosure.

FIG. 16 is a flowchart of a CSI compression feedback method of an embodiment of the disclosure.

FIG. 17 is a block diagram of a communication device of an embodiment of the disclosure.

FIG. 18 is a block diagram of a communication device of an embodiment of the disclosure.

FIG. 19 is a block diagram of a chip of an embodiment of the disclosure.

DETAILED DESCRIPTION

For ease of understanding, terms involved in this disclosure are introduced at first.

1. Channel state information (CSI)

In the field of wireless communications, CSI is a propagation characteristic of a communication link. It describes a signal attenuation factor on each transmission path in a communication link, i.e., a value of each element in a channel gain matrix, such as, signal scattering, environment attenuation, distance attenuation and other information. The CSI enables a communication system to adapt to a current channel condition and provides a guarantee for high-reliability and high-speed communication in a multi-antenna system.
The CSI is categorized into CSI on a transmitter side and CSI on a receiver side depending on an application location. Generally, the CSI on the transmitter side can be used to compensate for the attenuation in advance through means such as power allocation, beam forming and antenna selection, to complete high-speed and reliable data transmission.

2. Massive Multiple-Input Multiple-Output (mMIMO)

The mMIMO technology refers to using multiple transmitting and receiving antennas at the transmitter and the receiver, respectively, so that signals can be transmitted and received through the multiple antennas at the transmitter and the receiver, thereby improving the communication quality. The mMIMO can make full use of spatial resources, and exponentially improve a communication capacity of the system without increasing the spectral resources and the antenna transmission power.
The mMIMO technology has been used in the 4th generation (4G) communication and is intended to be used more widely in the 5th generation (5G) communication. The mMIMO in 4G communication has a maximum of 8 antennas, while 16/32/64/128 or even more massive antennas may be realized in 5G.
The mMIMO technology has following advantages: high multiplexing gain and diversity gain, high energy efficiency, and high spatial resolution. With respect to the high multiplexing gain and diversity gain, the spatial resolution of a large-scale MIMO system is significantly improved compared to a MIMO system in the related art. The large-scale MIMO system can deeply mine spatial dimension resources, so that multiple users within a coverage area of a base station can communicate with each other simultaneously on the same time-frequency resource by utilizing a degree of spatial freedom provided by the large-scale MIMO, and the large-scale MIMO system can also enhance a reuse capability of the spectrum resources among multiple terminals, thereby greatly improving a spectrum efficiency without increasing the density and bandwidth of the base station. For the high energy efficiency, the large-scale MIMO system can form narrower beams and concentrate radiation in a smaller spatial area, so that an energy efficiency on a radio frequency transmission link between the base station and a terminal can become higher and a transmission power loss of the base station can be reduced, which is an important technology for building future high-energy-efficient green broadband wireless communication systems. In regards to the high spatial resolution, the large-scale MIMO system have better robust performance. Since the number of antennas is much larger than the number of terminals, the system has a high degree of spatial freedom and a strong anti-interference capability. When the number of antennas at the base station tends to infinite, negative effects of additive white Gaussian noise and Rayleigh attenuation can all be ignored.

In order to better understand a CSI compression feedback method disclosed in embodiments of the disclosure, a communication system to which the embodiments of the disclosure is applied is first described below.

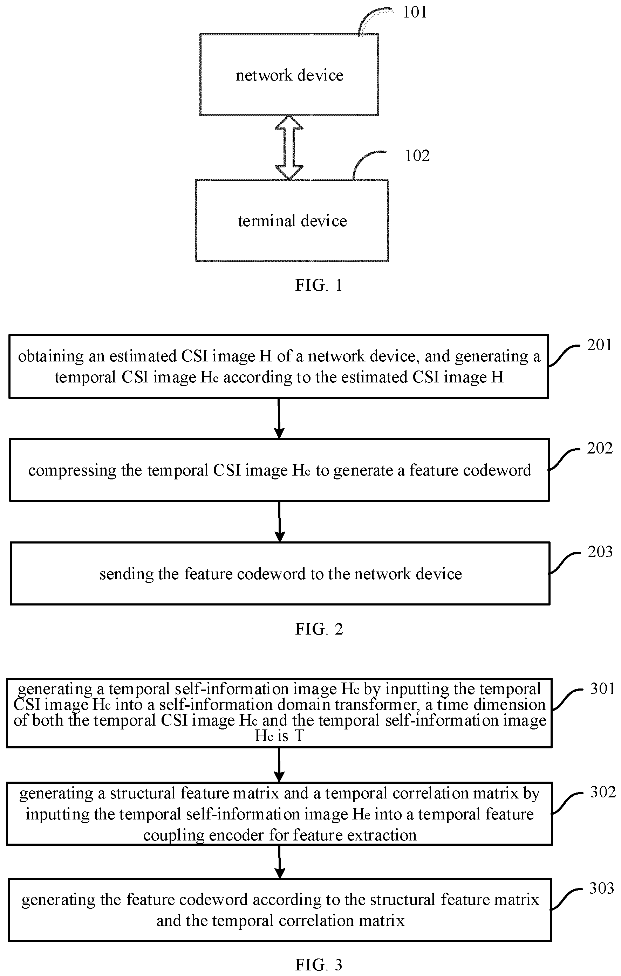

As illustrated in FIG. 1, FIG. 1 is a schematic diagram illustrating a communication system according to an embodiment of the disclosure. The communication system may include, but is not limited to, one network device and one terminal. The number and form of devices illustrated in FIG. 1 are only for examples and do not constitute a limitation on embodiments of the disclosure, and two or more network devices and two or more terminals may be included in practical applications. The communication system illustrated in FIG. 1 includes, for example, one network device 101 and one terminal 102.

It is noteworthy that technical solutions of embodiments of the disclosure can be performed by various communication systems, such as, a long term evolution (LTE) system, a 5G mobile communication system, a 5G NR system, or other future new mobile communication systems. It is also noted that the sidelink in embodiments of the disclosure may also be referred to as side link or direct link.

The network device 101 in embodiments of the disclosure is an entity on a network side for transmitting or receiving signals. For example, the network device 101 may be an evolved NodeB (eNB), a transmission reception point (TRP), a next generation NodeB (gNB) in a NR system, a base station in other future mobile communication systems, or an access node in a wireless fidelity (WiFi) system. The specific technology and specific device form adopted by the network device are not limited in embodiments of the disclosure. The network device according to embodiments of the disclosure may be composed of a central unit (CU) and distributed units (DUs). The CU may also be called a control unit. The use of the CU-DU structure allows to divide a protocol layer of the network device, such as a base station, such that some functions of the protocol layer are placed in the CU for centralized control, and some or all of the remaining functions of the protocol layer are distributed in the DUs, and the DUs are centrally controlled by the CU.

The terminal 102 in embodiments of the disclosure is an entity on a user side for receiving or transmitting signals, such as a cellular phone. The terminal may also be referred to as a terminal evice, user equipment (UE), a mobile station (MS), a mobile terminal (MT), and the like. The terminal can be a car with a communication function, a smart car, a mobile phone, a wearable device, a Pad, a computer with a wireless transceiver function a virtual reality (VR) terminal, an augmented reality (AR) terminal, a wireless terminal in industrial control, a wireless terminal in self-driving, a wireless terminal in remote medical surgery, a wireless terminal in smart grid, a wireless terminal in transportation safety, a wireless terminal in smart city, a wireless terminal in smart home, etc. The specific technology and specific device form adopted by the terminal are not limited in embodiments of the disclosure.

With the development of 5G wireless communication networks, the mMIMO has become a key technology. By configuring a large number of antennas, the mMIMO not only greatly improves a channel capacity under limited spectrum resources, but also has a strong anti-interference capability. In order to better utilize the mMIMO technology, a transmitter may obtain CSI. In the system, a UE estimates CSI of a downlink channel and then feeds back the CSI to a base station (BS) through a feedback link with a fixed bandwidth. However, due to the multi-antenna nature of the mMIMO, an overhead of CSI feedback is huge, and thus how to efficiently and accurately feed back the CSI remains a severe challenge.

In order to reduce the overhead of feeding back the CSI, researchers have proposed many algorithms based on the compression estimation theory, and most of them use the spatial and temporal correlation of the channel to reduce the overhead. In traditional compression methods, a compressed sensing (CS)-based feedback method transforms a CSI matrix into a sparse matrix under a certain basis and uses a computer-based method for feedback. A quantization-based codebook compression method quantizes the CSI into a certain number of bits. With the rapid development of deep learning in recent years, deep learning has been widely used in fields such as computer vision, speech signal processing and natural language processing. Since deep learning networks have powerful capabilities such as parallel computing, adaptive learning, and cross-domain knowledge sharing, deep learning methods are gradually being used in the CSI compression feedback field to further reduce the CSI feedback overhead. For example, a deep learning network achieves the purpose of CSI feedback by treating MIMO channel data as image information, compressing CSI using an encoder, and finally restoring it using a decoder. An improved deep learning network performs CSI compression and feedback by utilizing the temporal correlation of the channel.

In the related art, the CSI feedback method based on the spatial correlation of the channel utilizes a related algorithm to divide channel elements with spatial correlation into several clusters, and maps multiple channel elements in each cluster into a single characterization value, and several grouping modes are divided depending on a cluster classification method. A selected grouping mode and characterization value are fed back to a transmitter through a feedback link for CSI reconstruction. However, this method requires strong spatial correlation among channel elements, and it cannot achieve accurate CSI compression and feedback for channels with very small spatial correlation. Moreover, the algorithm of this method is rather complicated, and as the number of antennas of the transmitter increases, the number of clusters increases, and thus the feedback overhead is still huge.

In the related art, a CSI matrix in a space-frequency domain is transformed into a CSI matrix in an angle domain through a two-dimensional discrete Fourier transformation (DFT). The real and imaginary portions of the CSI matrix are separated to obtain two-dimensional CSI image information. In the angle domain, due to the time delay of multipath arrival and the sparsity of the mMIMO channel information matrix, a main value portion of the CSI image is extracted. The extracted CSI matrix is used as an input of a deep learning network for training. An encoder is deployed on the UE side and used to compress the extracted CSI image into a low-dimensional codeword, and a decoder is deployed on the base station side and used to restore the compressed low-dimensional codeword into a corresponding CSI image to obtain a reconstructed channel. Finally, offline training and parameter update are performed on the deep learning network to make the reconstructed channel as close as possible to the original channel in the angle domain. Finally, an inverse two-dimensional DFT transformation is performed on the reconstructed channel to obtain the original CSI matrix in the spatial frequency domain. The trained deep learning network model can be applied to online deployment applications.

However, the above-mentioned deep learning-based CSI compression and feedback method only uses the original channel parameters for compression and feedback. For temporal CSI with temporal correlation, the original channel parameters cannot well reflect a structural characteristic and a temporal correlation characteristic of the temporal CSI. The above method only compresses the CSI from the perspective of image, and cannot accurately compress and reconstruct the CSI using the temporal correlation characteristic for the temporal CSI with temporal correlation.

It can be understood that the communication system described in embodiments of the disclosure is intended to more clearly illustrate the technical solutions of embodiments of the disclosure, and does not constitute a limitation on the technical solutions provided in embodiments of the disclosure. Those skilled in the art may understand that as the system architecture evolves and new service scenarios emerge, the technical solutions according to embodiments of the disclosure are also applicable to similar technical problems.

The CSI compression feedback methods and the communication device provided in the disclosure are described in detail below in combination with the accompanying drawings.

As illustrated in FIG. 2, FIG. 2 is a flowchart of a CSI compression feedback method of an embodiment of the disclosure. The method can be applied to various communication systems, such as, a 5G mobile communication system, a 5G NR system, or other future new mobile communication systems. As illustrated in FIG. 2, the method is performed by a terminal. The method includes, but is not limited to the following steps.

At step 201, an estimated CSI image H of a network device is obtained, and a temporal CSI image $H_c$ is generated according to the estimated CSI image H.

In embodiments of the disclosure, in the communication between the terminal and the network device, a signal is transmitted by means of Frequency Division Duplex (FDD), which utilizes a frequency division multiplexing technique to separately transmit and receive signals. The upload and download range are separated according to a frequency offset. In the FDD mMIMO downlink, i.e., a channel from the network device to the terminal, multiple antennas are deployed at the network device, and mMIMO transmission is performed using Orthogonal Frequency Division Multiplexing (OFDM) technology with multiple subcarriers on the channel. In order to better transmit signals and improve the performance of the mMIMO system, the network device as the transmitter of the downlink may obtain CSI. The CSI is obtained by the terminal through channel estimation, and a size of the estimated CSI image H is $T \times c \times N_s \times Nt$. In the disclosure, the CSI acquired by the terminal has temporal correlation, i.e., the CSI includes a time sequence. $T$ represents a length of the time sequence, c represents a dimension of real and imaginary portions of the channel, and the channel has only one real portion and one imaginary portion, i.e., c=2. $N_s$ represents a number of subcarriers, and $N_t$ represents a number of antennas deployed at the network device.

The estimated CSI image H contains spatial domain information. In order to transform the estimated CSI image H to the angle domain, a two-dimensional DFT is performed on the estimated CSI image H, and the temporal CSI image $H_c$ can be obtained after the transformation. The temporal CSI image $H_c$ is more sparse compared to the estimated CSI image H. Due to the effect of the multipath delay, only the first $N_c$ rows in the transformed estimated CSI image H have values, so that $N_c$ is the number of valid rows and only data in the first $N_c$ rows are reserved, thus the size of the temporal CSI image $H_c$ is $T \times c \times N_c \times Nt$.

In a possible embodiment, 32 (i.e., $N_t$=32) antennas spaced by half wavelength are configured in a way of a Uniform Linear Array (ULA) on the network device, and a single antenna is configured on the terminal. Using the COST2100 channel model, 150,000 space-frequency domain CSI matrix samples are generated in a 5.3 GHz indoor microcellular scenario and divided into a training set containing 100,000 samples, a verification set containing 30,000 samples, and a test set containing 20,000 samples. The mMIMO system adopts the OFDM technique and there are 1024 subcarriers (i.e., $N_s$=1024), the CSI information matrix under the space-frequency domain is H = $[\tilde{h}_1 ... \tilde{h}_{N_s}]^H$, and a length $T$ of the time sequence of each CSI information matrix is set to $T$ = 5. In this case, the number of fed back parameters in each CSI information matrix is 1024 $\times$ 32, which is a huge overhead when the feedback bandwidth is limited.

To reduce the feedback overhead, the CSI information matrix H is transformed from the space-frequency domain to an angle delay domain using two-dimensional DFT, i.e., $H_c = F_d H F_a^H$, in which $F_d$ and $F_a^H$ are discrete Fourier transform matrices with sizes of 1024×1024 and 32×32, respectively, and the superscript H represents a conjugate transpose of the matrix. In the angle delay domain, using the delay characteristic of multipath arrival in a limited time period, the first $N_c = 32$ rows, i.e., the main value portion, of $H_c$ is extracted, and the size of the temporal CSI image $H_c$ in the angle domain is 5×2×32×32.

At step 202, the temporal CSI image $H_c$ is compressed to generate a feature codeword.

In embodiments of the disclosure, the temporal CSI image $H_c$ may be fed back to the network device. However, directly sending the temporal CSI image $H_c$ may occupy excessive channel resources and cause resource waste. Thus the temporal CSI image $H_c$ needs to be compressed and simplified to save resources. In embodiments of the disclosure, a self-information domain transformer projects the temporal CSI image into a self-information domain to obtain a temporal self-information image $H_e$. Due to the differences in information carried by various parts of a high-frequency channel image, by projecting the temporal CSI image into a self-information dimension, its structural feature and temporal correlation feature can be highlighted, and the temporal CSI image has a better compressibility in the self-information dimension.

The temporal self-information image $H_e$ is input into a temporal feature coupling encoder to use a recurrent neural network (e.g., Long Short-Term Memory (LSTM)) to extract the temporal correlation information among the self-information images. Meanwhile, structural feature information of the channel image projected on the self-information domain is obtained by using a one-dimensional space compression network, and the extracted temporal correlation information and structural feature information are summed up and coupled to obtain the final feature codeword that is implicitly fed back.

At step 203, the feature codeword is sent to the network device.

In embodiments of the disclosure, the temporal CSI image $H_c$ is compressed to obtain the feature codeword. The feature codeword contains information related to the temporal CSI image $H_c$. After the feature codeword is sent to the network device, the network device restores the feature codeword to obtain a restored temporal CSI image, and performs mMIMO transmission based on the restored CSI image.

By implementing the embodiments of the disclosure, the terminal compresses the temporal CSI image $H_c$ corresponding to the estimated CSI image H to generates the feature codeword, and the temporal CSI image can be fed back to the network device through the feature codeword, which can reduce channel resources occupied for feeding back the CSI image, thereby saving resources and improving the accuracy of feeding back the CSI image.

As illustrated in FIG. 3, FIG. 3 is a flowchart of a CSI compression feedback method of an embodiment of the disclosure. The method can be applied to various communication systems, such as, a 5G mobile communication system, a 5G NR system, or other future new mobile communication systems. As illustrated in FIG. 3, the method includes the following steps.

At step 301, a temporal self-information image $H_e$ is generated by inputting the temporal CSI image $H_c$ into a self-information domain transformer, in which a time dimension of both the temporal CSI image $H_c$ and the temporal self-information image $H_e$ is a time dimension of T.

In embodiments of the disclosure, the temporal CSI image $H_c$ is projected into the self-information domain by the self-information domain transformer to obtain the temporal self-information image $H_e$. Due to differences in information carried by various parts of a high-frequency channel image, by projecting the temporal CSI image into the self-information dimension, its structural features and temporal correlation features can be highlighted, and the temporal CSI image in the self-information dimension has better compressibility.

At step 302, a structural feature matrix and a temporal correlation matrix are generated by inputting the temporal self-information image $H_e$ into a temporal feature coupling encoder for feature extraction.

In embodiments of the disclosure, the structural feature and the temporal correlation feature of the temporal self-information image $H_e$ are extracted by the temporal feature coupling encoder. The structural feature matrix includes the structural features, and the temporal correlation matrix includes the temporal correlation features.

At step 303, the feature codeword is generated according to the structural feature matrix and the temporal correlation matrix.

In embodiments of the disclosure, the structural feature matrix and the temporal correlation matrix are coupled to obtain the feature codeword.

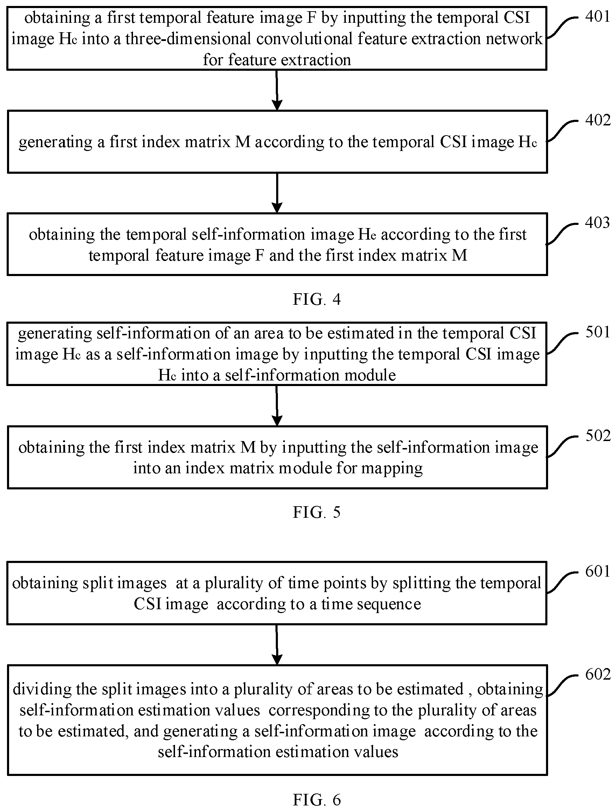

As illustrated in FIG. 4, FIG. 4 is a flowchart of a CSI compression feedback method of an embodiment of the disclosure. The method can be applied to various communication systems, such as, a 5G mobile communication system, a 5G NR system, or other future new mobile communication systems. As illustrated in FIG. 4, the method includes, but is not limited to the following steps.

At step 401a, a first temporal feature image F is obtained by inputting the temporal CSI image $H_c$ into a three-dimensional convolutional feature extraction network for feature extraction, in which a convolution kernel specification of the three-dimensional convolutional network is $f \times t \times n \times n$, $f$ represents a number of features to be extracted, $t$ represents a convolution depth in a time dimension, and $n$ represents a length and a width of a convolution window.

In embodiments of the disclosure, the temporal CSI image $H_c$ contains information of the time dimension, so that a two-dimensional convolutional layer is unable to effectively extract features in the image. In embodiments of the disclosure, a three-dimensional convolutional feature extraction network is used to extract features in the temporal CSI image. The three-dimensional convolutional network includes a convolutional layer, a three-dimensional normalization layer and an activation function layer. A convolutional kernel specification of the convolutional layer in the three-dimensional convolutional network is $f \times t \times n \times n$, which means that the convolutional kernel extracts $f$ features from the temporal CSI image $H_c$ during each convolution. In order to prevent gradient disappearing or gradient exploding, an output of the convolutional layer is input into the three-dimensional normalization layer for normalization, and then input into the activation function layer to obtain the first temporal feature image F, $F \in R^{T \times f \times N_c \times N_t}$. An activation function of the activation function layer is a LeakyReLU activation function, and an equation of the LeakyReLU activation function is expressed as follows:

$$\text{LeakyReLU}(x) = \begin{cases} x, & x \geq 0 \\ 0.3x, & x \leq 0 \end{cases}.$$

In a possible embodiment, the three-dimensional convolutional feature extraction network transforms the temporal CSI image $H_c$ into a first temporal feature image $F \in R^{5 \times 64 \times 32 \times 32}$, where 64 features are extracted from each CSI image, which corresponding to a dimension of 64. Since the temporal CSI image contains a time dimension on which a two-dimensional convolutional layer is incapable of performing effective feature extraction, and thus in the disclosure, the feature extraction network uses a three-dimensional convolutional layer with a convolutional kernel whose size is $64 \times 1 \times 3 \times 3$.

At step 401b, a first index matrix M is generated according to the temporal CSI image $H_c$.

In embodiments of the disclosure, the temporal CSI image $H_c$ may be input into a self-information module for extracting self-information when it is input into the three-dimensional convolutional feature extraction network. The self-information can be used to measure an amount of information contained when a single event occurs, and a self-information image is obtained according to the self-information. The self-information image is mapped through an index matrix module to obtain a second index matrix.

At step 402, the temporal self-information image $H_e$ is obtained according to the first temporal feature image F and the first index matrix M.

In embodiments of the disclosure, after obtaining the first temporal feature image F and the first index matrix M, the first temporal feature image F and the first index matrix M are multiplied point-to-point to obtain an information feature image (i.e., the second information feature image) with information redundancy removed, and dimension restoration is performed on the second information feature image to generate the temporal self-information image $H_e$.

As illustrated in FIG. 5, FIG. 5 is a flowchart of a CSI compression feedback method of an embodiment of the disclosure. The method can be applied to various communication systems, such as, a 5G mobile communication system, a 5G NR system, or other future new mobile communication systems. As illustrated in FIG. 5, the method includes, but is not limited to the following steps.

At step 501, self-information of an area to be estimated in the temporal CSI image $H_c$ is generated as a self-information image by inputting the temporal CSI image $H_c$ into a self-information module.

In embodiments of the disclosure, the temporal CSI image $H_c$ contains information of a time dimension, i.e., a time sequence. The self-information in the temporal CSI image $H_c$ at each time point in the time sequence may be computed, and the self-information at each time point constitutes a corresponding self-information image.

At step 502, the first index matrix M is obtained by inputting the self-information image into an index matrix module for mapping.

In embodiments of the disclosure, after obtaining the self-information image, the self-information image is input into the index matrix module. The index matrix module includes: a mapping network, a judger and a splicing module. The mapping module maps the self-information image to a self-information domain to obtain a second index matrix. The second index matrixes correspond to the temporal CSI images $H_c$ at respective time points in the time sequence respectively. In order to maintain the information of the time dimension, the second index matrixes may be spliced according to an order in the time sequence to obtain the first index matrix M.

As illustrated in FIG. 6, FIG. 6 is a flowchart of a CSI compression feedback method of an embodiment of the disclosure. The method can be applied to various communication systems, such as, a 5G mobile communication system, a 5G NR system, or other future new mobile communication systems. As illustrated in FIG. 6, the method includes, but is not limited to the following steps.

At step 601, split images $H_{c,i}$ at a plurality of time points are obtained by splitting the temporal CSI image $H_c$ according to a time sequence.

In embodiments of the disclosure, the temporal CSI image $H_c$ contains information of a time dimension, i.e., the time sequence. The self-information in the temporal CSI image $H_c$ at various time points in the time sequence may be calculated. The temporal CSI images $H_c$ is split according to the time sequence to obtain the split images $H_{c,i}$ at respective time points, $H_{c,i} \in R^{c \times N_c \times N_t}$, $i \in (1,2,\cdots, T)$, there are $T$ dimensions in the time sequence, so $T$ split images $H_{c,i}$ are obtained by the slitting.

At step 602, the split images are divided into a plurality of areas to be estimated $p_j$, self-information estimation values $\hat{I}_j$ corresponding to the plurality of areas to be estimated are obtained, and a self-information image $I_{c,i}$ is generated according to the self-information estimation values $\hat{I}_j$.

In embodiments of the disclosure, after obtaining the split images $H_{c,i}$, for each split image $H_{c,i}$, a real portion is represented by $\mathcal{R}(H_{c,i})$, and an imaginary portion is represented by $\mathcal{J}(H_{c,i})$. $\mathcal{R}(H_{c,i})$ and $\mathcal{J}(H_{c,i})$ are divided into a plurality of areas to be estimated using a window of a size of $n \times n$, and each area to be estimated is represented by $p_j \in R^{n \times n}$, $j \in [1,2,\cdots, (N_c - n + 1)(N_t - n + 1)]$. The self-information of each area $p_j$ is calculated by the following equation:

$$\hat{I}_j = -\log_2 \frac{1}{(2R+1)^2} \sum_{p'_{j,r} \in N_j} \frac{1}{\sqrt{2\pi}h} \exp\left(-\left\|p_j - p'_{j,r}\right\|_2^2 / 2h^2\right) + \text{constant}$$

where $\hat{I}_j$ represents the self-information estimation value of $p_j$; $N_j$ represents a set containing all the areas adjacent to $pj$; $p'_{j,r}$ is the $r^{th}$ area adjacent to $p_j$; $r = [1,2,\cdots, (2R+1)^2]$; R is the Manhattan radius, which is used for the determination of the boundary of $N_j$; $h$ is the bandwidth, which is used to adjust the influence of the distance between $p_j$ and $p'_{j,r}$ on calculating the self-information, and constant represents a constant value.

In a possible embodiment, the split CSI image is represented as $H_{c,i} \in R^{2 \times 32 \times 32}$, $i = (1,2,\cdots,5)$. For each $H_{c,i}$, the real portion is represented by $\mathcal{R}(H_{c,i})$ and the imaginary portion is represented by $\mathcal{J}(H_{c,i})$. $\mathcal{R}(H_{c,i})$ and $\mathcal{J}(H_{c,i})$ are divided into a plurality of areas using a window of a size of $1 \times 1$, each area is represented by $p_j \in R^{1 \times 1}$, $j = [1,2,\cdots,1024]$. In $p'_{j,r}$, $r = [1,2,\cdots,49]$. The Manhattan radius $R = 3$, the bandwidth $h = 1$, and the constant= $3 \times 10^{-6}$. In order to simplify the calculation, each pixel in $H_{c,i}$ is taken as an area and its self-information is calculated, and all the self-information values $\hat{I}_j$ constitute a matrix to obtain a self-information matrix $I_{c,i} \in R^{2 \times 32 \times 32}$ of $H_{c,i}$.

In a possible embodiment, to simplify the computation, each pixel in the $H_{c,i}$ is taken as an area for computing the self-information estimation value $\hat{I}_j$ of the $p_j$.

All the self-information values $\hat{I}_j$ form a matrix, to obtain a self-information image $I_{c,i} \in R^{c \times N_c \times N_t}$ of the $H_{c,i}$.

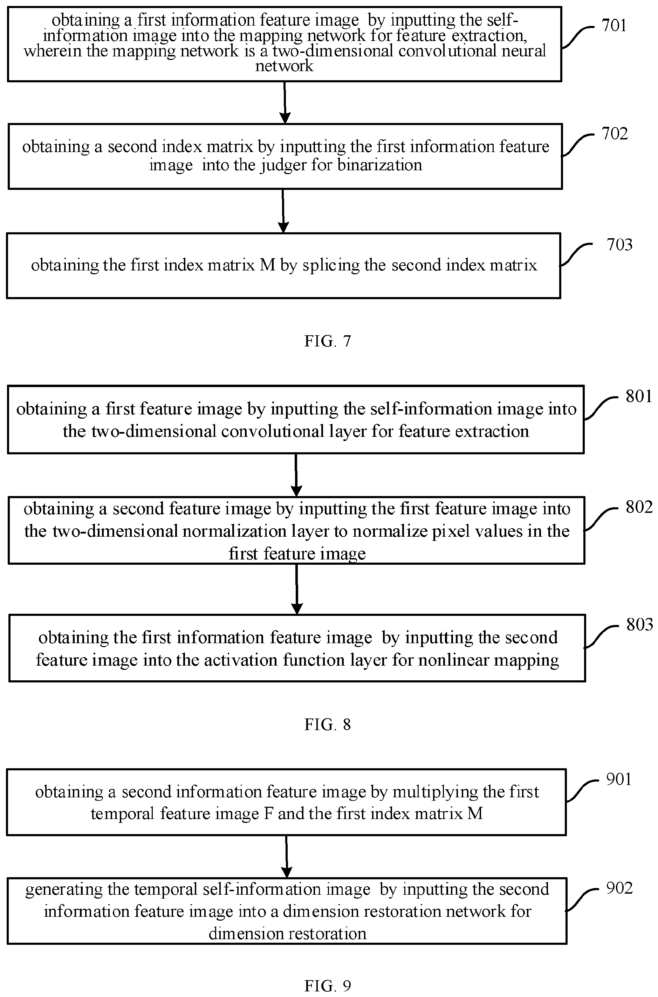

As illustrated in FIG. 7, FIG. 7 is a flowchart of a CSI compression feedback method of an embodiment of the disclosure. The method can be applied to various communication systems, such as, a 5G mobile communication system, a 5G NR system, or other future new mobile communication systems. As illustrated in FIG. 7, the method includes, but is not limited to the following steps.

At step 701, a first information feature image $D_{c,i}$ is obtained by inputting the self-information image into a mapping network for feature extraction, in which the mapping network is a two-dimensional convolutional neural network.

In embodiments of the disclosure, the mapping network includes a two-dimensional convolutional layer, a two-dimensional normalization layer and an activation function layer. The self-information image contains information of only two dimensions, so the size of a convolution kernel in the two-dimensional convolutional layer is $f \times n \times n$. After extracting features through the two-dimensional convolutional layer, the features are input into the two-dimensional normalization layer to normalize feature values, and then input into the activation function layer to obtain the first information feature image $D_{c,i}$. The activation function of the activation function layer is a LeakyReLU activation function.

At step 702, a second index matrix $M_i$ is obtained by inputting the first information feature image $D_{c,i}$ into a judger for binarization.

In embodiments of the disclosure, the judger performs binarization processing on the first information feature image $D_{c,i}$ and sets a threshold Y. For an element value corresponding to each element in the first information feature image $D_{c,i}$, if the element value is greater than or equal to the threshold Y set by the judger, an element corresponding to the element value is set to 1. If the element value is less than the threshold Y set by the judger, the element corresponding to the element value is set to 0. Thus, the second index matrix $M_i$ is obtained, where $M_i \in R^{f \times N_c \times N_t}$.

In a possible embodiment, the threshold Y=9.288, the judger sets the elements in $D_{c,i}$ whose values are less than 9.288 to 0, and the elements whose values are greater than 9.288 to 1, so that a final index matrix $M_i \in R^{64 \times 32 \times 32}$ is obtained.

At step 703, the first index matrix M is obtained by splicing the second index matrix $M_i$.

In embodiments of the disclosure, the split image $H_{c,i}$ corresponding to the second index matrix $M_i$ is an image at a time point in the temporal CSI image $H_c$, so that the second index matrix $M_i$ can be spliced in the order of the time sequence to obtain the first index matrix M.

As illustrated in FIG. 8, FIG. 8 is a flowchart of a CSI compression feedback method of an embodiment of the disclosure. The method can be applied to various communication systems, such as, a 5G mobile communication system, a 5G NR system, or other future new mobile communication systems. As illustrated in FIG. 8, the mapping network includes a two-dimensional convolutional layer, a two-dimensional normalization layer and an activation layer, the method includes, but is not limited to the following steps.

At step 801, a first feature image is obtained by inputting the self-information image into the two-dimensional convolutional layer for feature extraction.

In embodiments of the disclosure, the self-information image contains information of only two dimensions, so a size of a convolution kernel in the two-dimensional convolutional layer is $f \times n \times n$. The features are extracted by the two-dimensional convolutional layer to obtain the first feature image.

At step 802, a second feature image is obtained by inputting the first feature image into the two-dimensional normalization layer to normalize pixel values in the first feature image.

In embodiments of the disclosure, in order to prevent gradient disappearance and gradient explosion, the first feature image is input into the two-dimensional normalization layer, so that the value of each pixel in the second feature image is normalized to keep the size of the pixel value within a range of 0 to 1.

At step 803, the first information feature image $D_{c,i}$ is obtained by inputting the second feature image into the activation function layer for nonlinear mapping.

In embodiments of the disclosure, an activation function of the activation function layer is the LeakyReLU activation function.

In a possible embodiment, the mapping network maps $I_{c,i}$ into an information feature image $D_{c,i} \in R^{64 \times 32 \times 32}$, and a size of a convolution kernel of the two-dimensional convolutional layer in the mapping network is $64 \times 3 \times 3$.

Optionally, obtaining the first index matrix M by splicing the second index matrix $M_i$ includes:

obtaining the first index matrix M by splicing the second index matrix $M_i$ in an order of a time sequence.

In embodiments of the disclosure, the split image $H_{c,i}$ corresponding to the second index matrix $M_i$ is an image at a time point in the temporal CSI image $H_c$, so that the second index matrix $M_i$ can be spliced in the order of the time sequence to obtain the first index matrix M.

As illustrated in FIG. 9, FIG. 9 is a flowchart of a CSI compression feedback method of an embodiment of the disclosure. The method can be performed by various communication systems, such as, a 5G mobile communication system, a 5G NR system, or other future new mobile communication systems. As illustrated in FIG. 9, the method includes, but is not limited to the following steps.

At step 901, a second information feature image is obtained by multiplying the first temporal feature image F and the first index matrix M.

In embodiments of the disclosure, information redundancy is removed by the three-dimensional convolutional feature extraction network, the self-information module and the index matrix module, and the first temporal feature image F and the first index matrix M are obtained. The first temporal feature image F and the first index matrix M are multiplexed to obtain the second information feature image, and the information features in the second information feature image is refined and can better reflect the characteristics of the channel.

At step 902, the temporal self-information image $H_e$ is obtained by inputting the second information feature image into a dimension restoration network for dimension restoration.

In embodiments of the disclosure, the dimension restoration network includes a three-dimensional convolutional layer, a three-dimensional normalization layer and an activation function layer. A size of a convolution kernel of the three-dimensional convolution layer is $c \times t \times n \times n$, where $c$ is a restored dimension size, and $c$ is a dimension of the real and imaginary portions, so $c=2$; $t$ is the depth of the convolution in the time dimension; and $n \times n$ is the specification of a convolution window, i.e., the length and width of the convolution window are both n. The three-dimensional normalization layer performs a normalization process on an output of the three-dimensional convolution layer, and the activation function of the activation layer is a LeakyReLU activation function. The dimension restoration network performs dimension restoration on the second information feature image to obtain the temporal self-information image $H_e$. The temporal self-information image $H_e$ has more prominent structural features and temporal correlation features compared to the temporal CSI image $H_c$.

Optionally, the size of the convolution kernel of the three-dimensional convolutional layer in the dimension restoration network is $2 \times 1 \times 3 \times 3$.

Optionally, the temporal feature coupling encoder includes a one-dimensional time-space compression network and a coupling LSTM.

Optionally, generating the structural feature matrix and the temporal correlation matrix by inputting the temporal self-information image $H_e$ into the temporal feature coupling encoder for feature extraction includes:

obtaining the structural feature matrix by inputting the temporal self-information image $H_e$ subjected to dimension transformation into the one-dimensional time-space compression network for one-dimensional time-space compression, in which a convolution kernel specification of the one-dimensional time-space compression network is $S \times 2N_cN_t \times m$, $2N_cN_t$ represents a length of a convolution window, $m$ represents a width of the convolution window, $S$ represents a target dimension, and a dimension of the structural feature matrix is $T \times S$. $S = cN_cN_t/\sigma$, where $\sigma$ is a compression ratio.

In a possible embodiment, a size of a convolution kernel of the one-dimensional convolutional layer in the one-dimensional time-space compression network is $S \times 1$. The one-dimensional time-space compression network compresses the temporal self-information image $H_e$ into S-dimensional structural feature information according to the compression rate, where $S = 2048/\sigma$.

In embodiments of the disclosure, in order to save channel resources, the terminal feeds back the temporal self-information image $H_e$ to the network device in the form of the codeword. In order to transform the temporal self-information image $H_e$ into a feature codeword, the temporal feature coupling encoder extracts structural features and temporal correlation features of the temporal self-information image $H_e$ to generate the structural feature matrix and the temporal correlation matrix.

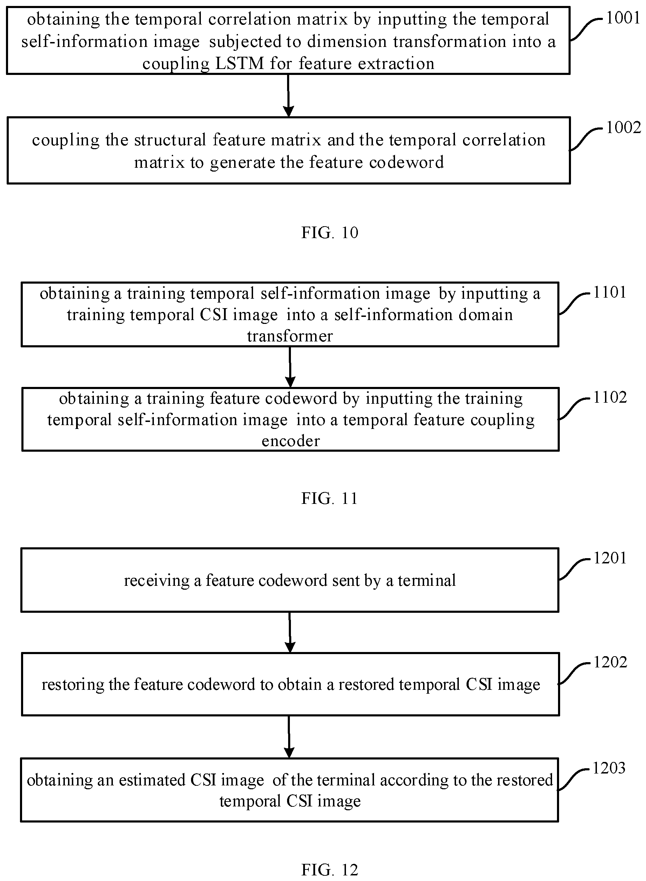

As illustrated in FIG. 10, FIG. 10 is a flowchart of a CSI compression feedback method of an embodiment of the disclosure. The method can be applied to various communication systems, such as, a 5G mobile communication system, a 5G NR system, or other future new mobile communication systems. As illustrated in FIG. 10, the method includes, but is not limited to the following steps.

At step 1001, the temporal correlation matrix by inputting the temporal self-information image $H_e$ subjected to dimension transformation into a coupling LSTM for feature extraction, in which a dimension of the temporal correlation matrix is $T \times S$.

In embodiments of the disclosure, dimension transformation is performed on the temporal self-information image $H_e$, it is input into the coupling LSTM. The LSTM contains a plurality of structural units suitable for processing and predicting important events with very long intervals and delays in the time sequence. The coupling LSTM extracts the temporal correlation features to generate the temporal correlation matrix. The dimension of the temporal correlation matrix is the same as the dimension of the structural feature matrix, which is $T \times S$.

In a possible embodiment, the number of structural units in the LSTM is $T$, which is equal to the time dimension of the temporal self-information image $H_e$. The structural units are connected in series, and an output of one structural unit is input into a next structural unit.

At step 1002, the structural feature matrix and the temporal correlation matrix are coupled to generate the feature codeword.

In embodiments of the disclosure, the dimension of the structural feature matrix and the temporal correlation feature matrix is the same, and the values of corresponding points in the structural feature matrix and the temporal correlation feature matrix are added and coupled to generate the feature codeword.

As illustrated in FIG. 11, FIG. 11 is a flowchart of a CSI compression feedback method of an embodiment of the disclosure. The method can be applied to various communication systems, such as, a 5G mobile communication system, a 5G NR system, or other future new mobile communication systems. As illustrated in FIG. 11, the method includes, but is not limited to the following steps.

At step 1101, a training temporal self-information image $H_e$ is obtained by inputting a training temporal CSI image $H_c$ into a self-information domain transformer.

**In** embodiments of the disclosure, the self-information domain transformer and the temporal feature coupling encoder in the terminal may be trained by inputting the training temporal CSI image $H_c$ into the self-information domain transformer to obtain the training temporal self-information image $H_e$.

At step 1102, a training feature codeword is obtained by inputting the training temporal self-information image $H_e$ into a temporal feature coupling encoder.

In embodiments of the disclosure, the training temporal self-information image $H_e$ is input into the temporal feature coupling encoder to obtain the training feature codeword. After preliminary training, network parameters of the self-information domain transformer and the temporal feature coupling encoder are obtained.

Optionally, the method further includes:

sending training data to the network device, in which the training data includes the training feature codeword, a time-sequence length of a temporal self-information image $H_e$, a dimension of the training feature codeword, and a training temporal CSI image $H_c$.

In embodiments of the disclosure, in order for the network device to successfully decode the information in the feature codeword, the training data may be send to the network device to adjust the network parameters of the decoupling module in the network device.

As illustrated in FIG. 12, FIG. 12 is a flowchart of a CSI decompression feedback method of an embodiment of the disclosure. The method can be applied to various communication systems, such as, a 5G mobile communication system, a 5G NR system, or other future new mobile communication systems. As illustrated in FIG. 12, the method is performed by a network device, and the method includes, but is not limited to the following steps.

At step 1201, a feature codeword sent by a terminal is received.

In embodiments of the disclosure, the network device acts as a transmitter of downlink, and in order to better transmit signals and improve the performance of the mMIMO system, the network device may obtain CSI. A temporal CSI image is restored according to the feature codeword sent by the terminal.

At step 1202, the feature codeword is restored to obtain a restored temporal CSI image $H_c$.

In embodiments of the disclosure, the terminal restores the feature codeword by a decoupling module and a restoration convolutional neural network to obtain the restored temporal CSI image $H_c$. The decoupling module includes a one-dimensional time-space decompression network and a decoupling LSTM. The size of the restored temporal CSI image $\hat{H}_c$ is the same as the size of the temporal CSI image $H_c$, which is $T \times c \times N_c \times Nt$.

At step 1203, an estimated CSI image $\hat{H}$ is obtained according to the restored temporal CSI image $\hat{H}_c$.

In embodiments of the disclosure, a two-dimensional DFT inverse transform is performed on the restored temporal CSI image $\hat{H}_c$ to obtain the estimated CSI image $\hat{H}$ required by the network device.

By implementing embodiments of the disclosure, the network device decompresses the feature codeword compressed by the terminal to obtain the restored estimated CSI image $\hat{H}$, which can reduce the channel resources occupied by feeding back CSI images, thereby saving resources and improving the accuracy of feeding back the CSI image.

Optionally, restoring the feature codeword, includes:
obtaining the restored temporal CSI image $\hat{H}_c$ by inputting the feature codeword into a temporal feature coupling decoder to obtain the restored temporal CSI image $\hat{H}_c$.

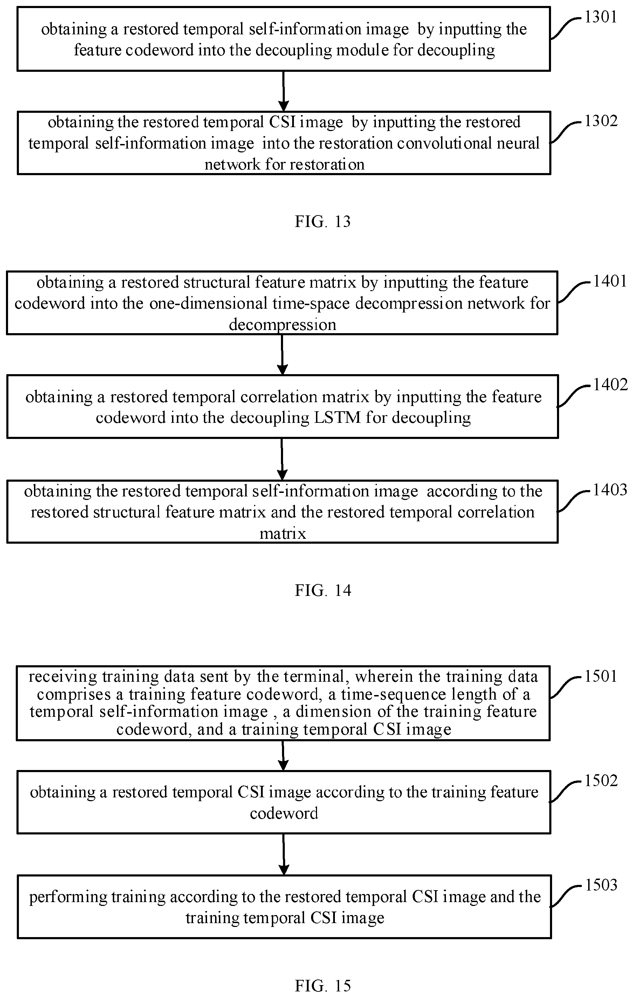

As illustrated in FIG. 13, FIG. 13 is a flowchart of a CSI decompression feedback method of an embodiment of the disclosure. The method can be applied to various communication systems, such as, a 5G mobile communication system, a 5G NR system, or other future new mobile communication systems. As illustrated in FIG. 13, the temporal feature decoupling decoder includes a decoupling module and a restoration convolutional neural network, the method includes, but is not limited to the following steps.

At step 1301, a restored temporal self-information image $\hat{H}_e$ is obtained by inputting the feature codeword into the decoupling module for decoupling.

In embodiments of the disclosure, the decoupling module includes a one-dimensional time-space decompression network and a decoupling LSTM. The decoupling module is structurally symmetric with the temporal feature coupling encoder of the network device. The one-dimensional time-space decompression network is used for extracting structural feature information in the feature codeword, and the decoupling LSTM is used for extracting temporal correlation information in the feature codeword.

At step 1302, the restored temporal CSI image $\hat{H}_c$ is obtained by inputting the restored temporal self-information image $\hat{H}_e$ into the restoration convolutional neural network for restoration.

In embodiments of the disclosure, the restoration convolutional neural network is used to restore a corresponding restored temporal CSI image $\hat{H}_c$ according to the restored temporal self-information image $\hat{H}_e$.

As illustrated in FIG. 14, FIG. 14 is a flowchart of a CSI decompression feedback method of an embodiment of the disclosure. The method can be applied to various communication systems, such as, a 5G mobile communication system, a 5G NR system, or other future new mobile communication systems. As illustrated in FIG. 14, the decoupling decoder includes a one-dimensional time-space decompression network and a decoupling LSTM, the method includes, but is not limited to the following steps.

At step 1401, a restored structural feature matrix is obtained by inputting the feature codeword into the one-dimensional time-space decompression network for decompression.

In embodiments of the disclosure, the one-dimensional time-space decompression network includes a one-dimensional convolutional layer, which contains a plurality of one-dimensional convolutional kernels.

At step 1402, a restored temporal correlation matrix is obtained by inputting the feature codeword into the decoupling LSTM for decoupling.

At step 1403, the restored temporal self-information image $\hat{H}_e$ is obtained according to the restored structural feature matrix and the restored temporal correlation matrix.

In embodiments of the disclosure, the dimension of the restored structural feature matrix and the restored temporal correlation matrix is the same, which is $T \times cN_cN_t$. The restored structural feature matrix and the restored temporal correlation matrix are added point-to-point, and dimension transform is performed on the result of the adding to obtain the restored temporal self-information image $\hat{H}_e$.

Optionally, the convolution kernel specification of the one-dimensional time-space decompression network is $2N_cN_t \times S \times$ m. The $T$ is the number of rows of the restored temporal correlation matrix, and $2N_cN_t$ is the number of columns of the restored temporal correlation matrix.

Optionally, obtaining the restored temporal self-information image $\hat{H}_e$ according to the restored structural feature matrix and the restored temporal correlation matrix includes:
adding the restored structural feature matrix and the restored temporal correlation matrix point by point and performing dimension transformation to obtain the restored temporal self-information image $\hat{H}_e$.

Optionally, the restored convolution neural network includes a first convolutional layer, a second convolutional layer, a third convolutional layer, a fourth convolutional layer, a fifth convolutional layer, a sixth convolutional layer, and a seventh convolutional layer. A convolution kernel specification of the first convolutional layer and the fourth convolutional

layer is $l_1 \times t \times n \times n$, a convolution kernel specification of the second convolutional layer and the fifth convolutional layer is $l_2 \times t \times n \times n$, and a convolution kernel specification of the third convolutional layer, the sixth convolutional layer and the seventh convolutional layer is $2 \times t \times n \times n$, $t$ represents a convolution depth in a time dimension, $l_1$, $l_2$ and 2 are numbers of extracted features, and $n$ represents a length and a width of a convolution window.

In a possible embodiment, the convolution kernel of the first convolution layer is $8 \times 1 \times 3 \times 3$, the convolution kernel of the second convolution layer is $16 \times 1 \times 3 \times 3$, the convolution kernel of the third convolution layer is $2 \times 1 \times 3 \times 3$, the convolution kernel of the fourth convolution layer is $8 \times 1 \times 3 \times 3$, the convolution kernel of the fifth convolution layer is $16 \times 1 \times 3 \times 3$, and the convolution kernel of the sixth convolution layer is $2 \times 1 \times 3 \times 3$. The step size of the first six three-dimensional convolution layers is 1, and the activation function adopts the LeakyReLU function. The seventh convolutional layer is a normalization layer with a convolution kernel of $2 \times 1 \times 3 \times 3$ and a step size of 1.

Optionally, obtaining the restored temporal CSI image $\hat{H}_c$ by inputting the restored temporal self-information image $\hat{H}_e$ into the restoration convolutional neural network for restoration includes:

obtaining a first restored feature map by inputting the restored temporal self-information image $\hat{H}_e$ into the first convolutional layer for convolution, obtaining a second restored feature map by inputting the first restored feature map into the second convolutional layer, obtaining a third restored feature map by inputting the second restored feature map into the third convolutional layer, and obtaining a fourth restored feature map by adding the third restored feature map with the restored temporal self-information image $\hat{H}_e$;

obtaining a fifth restored feature map by inputting the fourth restored feature map into the fourth convolutional layer, obtaining a sixth restored feature map by inputting the fifth reduced feature map into the fifth convolutional layer, obtaining a seventh restored feature map by inputting the sixth restored feature map into the sixth convolutional layer, and obtaining an eighth restored feature map by adding the fourth restored feature map with the seventh restored feature map; and

obtaining the restored temporal CSI image $\hat{H}_c$ by inputting the eighth restored feature image into the seventh convolutional layer for normalization.

In embodiments of the disclosure, in order to prevent gradient disappearance during the training of the rebuilt CSI module, short-circuiting operations are performed on the first and fourth three-dimensional convolutional layers, and on the fourth and sixth three-dimensional convolutional layers. The step size of the first convolutional layer, the second convolutional layer, the third convolutional layer, the fourth convolutional layer, the fifth convolutional layer, and the sixth convolutional layer is k. The activation function of each convolutional layer is a Sigmoid function, and the equation of the Sigmoid function is:

$$S(x) = \frac{1}{1+e^{-x}} \quad .$$

As illustrated in FIG. 15, FIG. 15 is a flowchart of a CSI decompression feedback method of an embodiment of the disclosure. The method can be applied to various communication systems, such as, a 5G mobile communication system, a 5G NR system, or other future new mobile communication systems. As illustrated in FIG. 15, the method includes, but is not limited to the following steps.

At step 1501, training data sent by the terminal is received, in which the training data includes a training feature codeword, a time-sequence length of a temporal self-information image $H_e$, a dimension of the training feature codeword, and a training temporal CSI image.

In embodiments of the disclosure, the decoupling module and the restoration convolutional neural network in the temporal feature decoupling decoder deployed by the terminal may be trained. Training is performed according to the training data sent by the terminal.

At step 1502, a restored temporal CSI image is obtained according to the training feature codeword.

In embodiments of the disclosure, the training feature codeword is input into the temporal feature decoupling decoder for restoration to obtain the restored CSI image.

At step 1503, training is performed according to the restored temporal CSI image and the training temporal CSI image.

In embodiments of the disclosure, the network parameters in the temporal feature decoupling decoder may be optimized to make the restored temporal CSI image and the training temporal CSI image as close as possible.

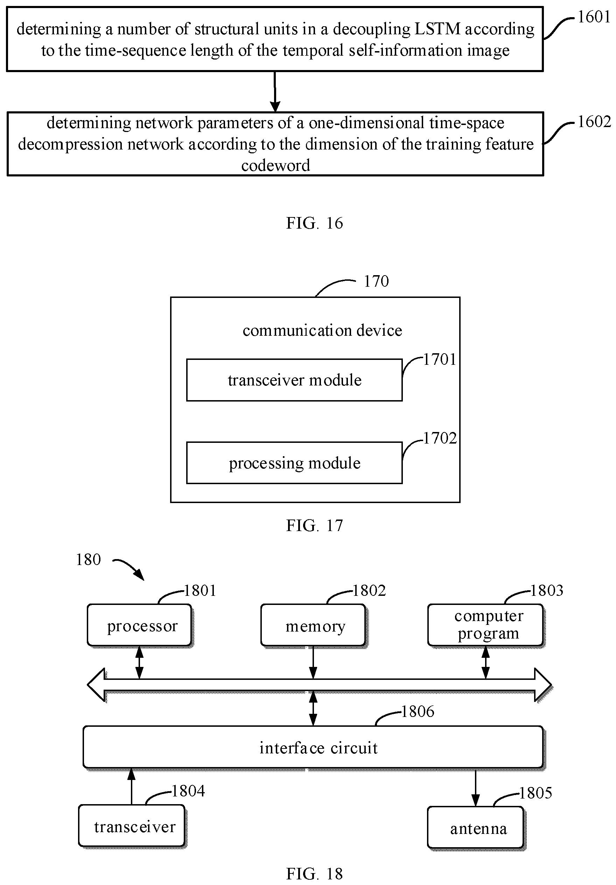

As illustrated in FIG. 16, FIG. 16 is a flowchart of a CSI decompression feedback method of an embodiment of the disclosure. The method can be applied to various communication systems, such as, a 5G mobile communication system, a 5G NR system, or other future new mobile communication systems. As illustrated in FIG. 16, the method includes, but is not limited to the following steps.

At step 1601, a number of structural units in the decoupling LSTM is determined according to a time-sequence length of the temporal self-information image $H_e$.

In embodiments of the disclosure, in order to enhance the effect of decoupling, the structure of the decoupling LSTM may be symmetrical with the structure of the coupling LSTM. The number of structural units in the coupling LSTM is $T$, which is the same as the length of the time sequence of the temporal self-information image $H_e$, so the number of structural units in the decoupling LSTM may be equal to $T$. The structural units in the decoupling LSTM are connected in series.

At step 1602, network parameters of the one-dimensional time-space decompression network is determined according to the dimension of the training feature codeword.

In embodiments of the disclosure, the structure of the one-dimensional time-space decompression network is the same as the structure of the one-dimensional time-space compression network. The number of features extracted by the one-dimensional time-space compression network is $S$, and thus the number of features decompressed by the one-dimensional time-space decompression network is also $S$. The dimension of the training feature codeword is $T \times S$, and the size of the one-dimensional convolution kernel in the one-dimensional time-space decompression network is $2N_cN_t \times S \times m$.

Optionally, the method includes:

performing multiple rounds of training, in which an equation of a learning rate in the training is represented as:

$$\gamma = \gamma_{min} + \frac{1}{2}(\gamma_{max} + \gamma_{min})[1 + cos(\frac{t-T_w}{T'-T_w}\pi)],$$

where $\gamma$ represents a current learning rate, $\gamma_{max}$ represents a maximum learning rate, $\gamma_{min}$ represents a minimum learning rate, $t$ represents a current number of training rounds, $T_w$ represents a number of gradual learnings, $T'$ represents a number of overall training cycles.

In embodiments of the disclosure, during the training process, in order for the network to learn a global optimal solution, the learning rate of the network adopts the "asymptotic learning" method, in which the learning rate grows linearly in the first few training cycles, and then after reaching the peak, the learning rate decreases slowly in a cosine trend. The decreasing trend is as shown in the above expression of the equation of the learning rate.

In a possible embodiment, the learning rate grows linearly in the first 30 learning cycles, and after reaching the peak, the learning rate slowly decreases in a cosine trend, where $\gamma_{max} = 2 \times 10^{-3}$, $\gamma_{min} = 5 \times 10^{-5}$, $T_w = 30$, $T' = 2000$.

Optionally, the method includes:
obtaining recommended network parameters for the decoupling module and the restored convolutional neural network, and updating the decoupling module and the restored convolutional neural network according to the recommended network parameters.

In embodiments of the disclosure, after the training is completed, the recommended network parameters of the decoupling module and the restoration convolutional neural network can be obtained, and the decoupling module and the restoration convolutional neural network can be updated according to the recommended network parameters.

In a possible embodiment, the self-information domain transformer of the terminal is used to generate the temporal self-information image $H_e$. The temporal self-information image $H_e$ is input into the temporal feature coupling encoder to generate the feature codeword. The temporal feature coupling decoder in the network device is used to restore the feature codeword to a restored temporal CSI image $\hat{H}_c$. The restored estimated CSI image $\hat{H}$ is obtained by performing a 2D DFT inverse transformation on the $\hat{H}_c$. The network parameters are continuously updated during the transmission of the feature codeword.

Optionally, the method further includes followings. After the terminal obtains the feature codeword through the temporal feature coupling encoder, e-bit quantization is performed on the codeword for ease of transmission before being fed back to the network device. By using the trained network parameters, the restored temporal CSI image $\hat{H}_c$ is obtained after inverse quantization is performed and the temporal feature decoupling decoding by the network device.

Optionally, 64-bit quantization is performed on the codeword before feeding back to the network device.

In the above-described embodiments provided in the disclosure, the method provided in embodiments of the disclosure is described from the perspective of a network device and a first terminal, respectively. In order to realize each of the above-described functions in the method provided by embodiments of the disclosure, the network device and the first terminal may include a hardware structure and/or a software module, and realize each of the above-described functions in the form of a hardware structure, a software module, or a combination of the hardware structure and the software module. A certain function of the above-described functions may be performed in the form of a hardware structure, a software module, or a combination of the hardware structure and the software module.

FIG. 17 is a schematic diagram of a communication device 170 provided by an embodiment of the disclosure. The communication device 170 shown in FIG. 17 may include a transceiver module 1701 and a processing module 1702. The transceiver module 1701 may include a transmitting module and/or a receiving module, the transmitting module is used to implement a transmitting function, and the receiving module is used to implement a receiving function. The transceiver module 1701 may implement a transmitting function and/or a receiving function.

The communication device 170 may be a terminal (e.g., the first terminal in the above method embodiments), a device in the terminal, or a device capable of being used together with the terminal. Alternatively, the communication device 170 may be a network device, a device in the network device, or a device capable of being used together with the network device.

When implemented as a terminal, the communication device 170 includes:

an estimation module, configured to obtain an estimated CSI image H of a network device, and generate a temporal CSI image $H_c$ according to the estimated CSI image H;
a compressing module, configured to compress the temporal CSI image $H_c$ to generate a feature codeword; and
a sending module, configured to send the feature codeword to the network device.

When implemented as a network device, the communication device 170 includes:

a receiving module, configured to receive a feature codeword sent by a terminal;
a restoring module, configured to restore the feature codeword to obtain a restored temporal CSI image $H_c$; and
a channel obtaining module, configured to obtain a restored estimated CSI image $\hat{H}$ according to the restored temporal CSI image $\hat{H}_c$.

As illustrated in FIG. 18, FIG. 18 is a schematic diagram illustrating a communication device 180 according to an embodiment of the disclosure. The communication device 180 may be a network device, a terminal (e.g., the first terminal according to the above method embodiments), or a chip, a chip system or a processor that supports the network device to realize the above-described methods, or a chip, a chip system or a processor that supports the terminal to realize the above-described methods. The device may be used to realize the methods described in the above method embodiments with reference to the descriptions of the above-described method embodiments.

The communication device 180 may include one or more processors 1801. The processor 1801 may be a general purpose processor or a dedicated processor, such as, a baseband processor or a central processor. The baseband processor is used for processing communication protocols and communication data. The central processor is used for controlling the communication device (e.g., base station, baseband chip, terminal, terminal chip, DU, or CU), executing computer programs, and processing data of the computer programs.

Optionally, the communication device 180 may include one or more memories 1802 on which computer programs 1804 may be stored. The processor 1801 executes the computer programs 1804 to cause the communication device 180 to perform the methods described in the above method embodiments. Optionally, data may also be stored in the memory 1802. The communication device 180 and the memory 1802 may be provided separately or may be integrated together.

Optionally, the communication device 180 may also include a transceiver 1805 and an antenna 1806. The transceiver 1805 may be referred to as transceiver unit, transceiver machine, or transceiver circuit, for realizing the transceiver function. The transceiver 1805 may include a receiver and a transmitter. The receiver may be referred to as receiver machine or receiving circuit, for realizing the receiving function. The transmitter may be referred to as transmitter machine or transmitting circuit, for realizing the transmitting function.

Optionally, the communication device 180 may also include one or more interface circuits 1807. The interface circuits 1807 are used to receive code instructions and transmit them to the processor 1801. The processor 1801 runs the code instructions to cause the communication device 180 to perform the method described in the method embodiments.

In an implementation, the processor 1801 may include a transceiver for implementing the receiving and transmitting functions. The transceiver may be, for example, a transceiver circuit, an interface, or an interface circuit. The transceiver circuit, interface, or interface circuit for implementing the receiving and transmitting functions may be separated or may be integrated together. The transceiver circuit, interface, or interface circuit described above may be used for code/data reading and writing, or may be used for signal transmission or delivery.

In an implementation, the processor 1801 may store a computer program 1803, which runs on the processor 1801 and may cause the communication device 180 to perform the methods described in the method embodiments above. The computer program 1803 may be solidified in the processor 1801, in which case the processor 1801 may be implemented by hardware.

In an implementation, the communication device 180 may include circuits. The circuits may implement the sending, receiving or communicating function in the preceding method embodiments. The processors and transceivers described in this disclosure may be implemented on integrated circuits (ICs), analog ICs, radio frequency integrated circuits (RFICs), mixed signal ICs, application specific integrated circuits (ASICs), printed circuit boards (PCBs), and electronic devices. The processors and transceivers can also be produced using various IC process technologies such as complementary metal oxide semiconductor (CMOS), nMetal-oxide-semiconductor (NMOS), positive channel metal oxide semiconductor (PMOS), bipolar junction transistor (BJT), bipolar CMOS (BiCMOS), silicon-germanium (SiGe), gallium arsenide (GaAs) and so on.

The communication device in the above description of embodiments may be a network device or a terminal (e.g., the first terminal in the above method embodiments), but the scope of the communication device described in the disclosure is not limited thereto, and the structure of the communication device may not be limited by FIG. 18. The communication device may be a stand-alone device or may be part of a larger device. For example, the described communication device may be:

(1) a stand-alone IC, chip, chip system or subsystem;
(2) a collection of ICs including one or more ICs, optionally, the collection of ICs may also include storage components for storing data and computer programs;
(3) an ASIC, such as a modem;
(4) modules that can be embedded within other devices;
(5) receivers, terminals, smart terminals, cellular phones, wireless devices, handheld machines, mobile units, in-vehicle devices, network devices, cloud devices, artificial intelligence devices, and the like; and
(6) others.

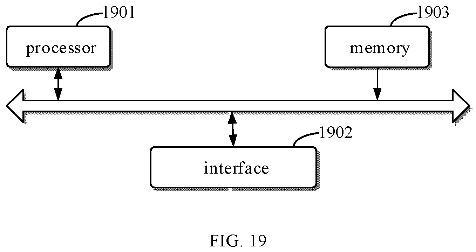

The case where the communication device may be a chip or a chip system is described with reference to the schematic structure of the chip shown in FIG. 19. The chip shown in FIG. 19 includes a processor 1901 and an interface 1902. There may be one or more processors 1901, and there may be multiple interfaces 1902.

Optionally, the chip further includes a memory 1903 used for storing necessary computer programs and data.

It is understandable by those skilled in the art that various illustrative logical blocks and steps listed in embodiments of the disclosure may be implemented by electronic hardware, computer software, or a combination of both. Whether such function is implemented by hardware or software depends on the particular application and the design requirements of the entire system. Those skilled in the art may, for each particular application, use various methods to implement the described function, but such implementation should not be construed as being beyond the scope of protection of embodiments of the disclosure.

Embodiments of the disclosure also provide a CSI compression feedback system. The system includes a communication device as a terminal (e.g., the first terminal in the above method embodiments) and a communication device as a network device in the preceding embodiment of FIG. 7. Or, the system includes a communication device as a terminal (e.g., the first terminal in the above method embodiments) and a communication device as a network device in the preceding embodiment of FIG. 18.

The disclosure also provides a readable storage medium having instructions stored thereon. When the instructions are executed by a computer, the function of any of the method embodiments described above is implemented.

The disclosure also provides a computer program product. When the computer program product is executed by a computer, the function of any of the method embodiments described above is implemented.

The above embodiments may be implemented in whole or in part by software, hardware, firmware, or any combination thereof. When implemented using software, it may be implemented, in whole or in part, in the form of a computer program product. The computer program product includes one or more computer programs. When loading and executing the computer program on the computer, all or part of processes or functions described in embodiments of the disclosure is implemented. The computer may be a general-purpose computer, a dedicated computer, a computer network, or other programmable devices. The computer program may be stored in a computer-readable storage medium or transmitted from one computer-readable storage medium to another computer-readable storage medium. For example, the computer program may be transmitted from one web site, computer, server, or data center to another web site, computer, server, or data center, in a wired manner (e.g., by using coaxial cables, fiber optics, or digital subscriber lines (DSLs) or wirelessly (e.g., by using infrared wave, wireless wave, or microwave). The computer-readable storage medium may be any usable medium to which the computer has access to or a data storage device such as a server and a data center integrated by one or more usable mediums. The usable medium may be a magnetic medium (e.g., floppy disk, hard disk, and tape), an optical medium (e.g., a high-density digital video disc (DVD)), or a semiconductor medium (e.g., a solid state disk (SSD)).

Those skilled in the art may understand that "first", "second" and other various numerical numbers involved in the disclosure are only described for the convenience of differentiation, and are not used to limit the scope of embodiments of the disclosure, or used to indicate the order of precedence.

The term "at least one" in the disclosure may also be described as one or more, and the term "multiple" may be two, three, four, or more, which is not limited in the disclosure. In embodiments of the disclosure, for a type of technical features, "first", "second", and "third", and "A", "B", "C" and "D" are used to distinguish different technical features of the type, the technical features described using the "first", "second", and "third", and "A", "B", "C" and "D" do not indicate any order of precedence or magnitude.

The correspondences shown in the tables in this disclosure may be configured or may be predefined. The values of information in the tables are merely examples and may be configured to other values, which are not limited by the disclosure. In configuring the correspondence between the information and the parameter, it is not necessarily required that all the correspondences illustrated in the tables must be configured. For example, the correspondences illustrated in certain rows in the tables in this disclosure may not be configured. For another example, the above tables may be adjusted appropriately, such as splitting, combining, and the like. The names of the parameters shown in the titles of the above tables may be other names that can be understood by the communication device, and the values or representations of the parameters may be other values or representations that can be understood by the communication device. Each of the above tables may also be implemented with other data structures, such as, arrays, queues, containers, stacks, linear tables, pointers, chained lists, trees, graphs, structures, classes, heaps, and Hash tables.

The term "predefine" in this disclosure may be understood as define, define in advance, store, pre-store, pre-negotiate, pre-configure, solidify, or pre-fire.

Those skilled in the art may realize that the units and algorithmic steps of the various examples described in combination with embodiments disclosed herein are capable of being implemented in the form of electronic hardware, or a combination of computer software and electronic hardware. Whether these functions are performed in the form of hardware or software depends on the specific application and design constraints of the technical solution. Those skilled in the art may use different methods to implement the described functions for each particular application, but such implementations should not be considered as beyond the scope of the disclosure.

It is clearly understood by those skilled in the field to which it belongs that, for the convenience and brevity of description, the specific working processes of the systems, apparatuses, and units described above can be referred to the corresponding processes in the preceding method embodiments, and will not be repeated herein.

It will be appreciated that the disclosure is not limited to the exact construction that has been described above and illustrated in the accompanying drawings, and that various modifications and changes can be made. It is intended that the scope of the disclosure only be limited by the appended claims.

**Claims**

1. A channel state information, CSI, compression feedback method, performed by a terminal, comprising:

    obtaining (201) an estimated CSI image H of a network device, and generating a temporal CSI image $H_c$ according to the estimated CSI image H;
    compressing (202) the temporal CSI image $H_c$ to generate a feature codeword; and
    sending (203) the feature codeword to the network device; **characterized in that** compressing (202) the temporal CSI image $H_c$ to generate the feature codeword comprises:

    generating (301) a temporal self-information image $H_e$ by inputting the temporal CSI image $H_c$ into a self-information domain transformer, wherein a time dimension of both the temporal CSI image $H_c$ and the temporal self-information image $H_e$ is T;
    generating (302) a structural feature matrix and a temporal correlation matrix by inputting the temporal self-information image $H_e$ into a temporal feature coupling encoder for feature extraction; and
    generating (303) the feature codeword according to the structural feature matrix and the temporal correlation matrix.

2. The method of claim 1,
    wherein generating (301) the temporal self-information image $H_e$ by inputting the temporal CSI image $H_c$ into the self-information domain transformer comprises:

    obtaining (401) a first temporal feature image F by inputting the temporal CSI image $H_c$ into a three-dimensional convolutional feature extraction network for feature extraction, wherein a convolution kernel specification of the three-dimensional convolutional network is $f \times t \times n \times n$, $f$ represents a number of features to be extracted, t represents a convolution depth in a time dimension, and n represents a length and a width of a convolution window;
    generating (402) a first index matrix M according to the temporal CSI image $H_c$; and
    obtaining (403) the temporal self-information image $H_e$ according to the first temporal feature image F and the first index matrix M.

3. The method of claim 2, wherein generating (402) the first index matrix M according to the temporal CSI image $H_c$ comprises:

> generating (501) self-information of an area to be estimated in the temporal CSI image $H_c$ as a self-information image by inputting the temporal CSI image $H_c$ into a self-information module; and
> obtaining (502) the first index matrix M by inputting the self-information image into an index matrix module for mapping; or
> wherein obtaining (403) the temporal self-information image $H_e$ according to the first temporal feature image F and the first index matrix M comprises:

>> obtaining (901) a second information feature image by multiplying the first temporal feature image F and the first index matrix M; and
>> generating (902) the temporal self-information image $H_e$ by inputting the second information feature image into a dimension restoration network for dimension restoration.

4. The method of claim 3, wherein generating (501) the self-information of the area to be estimated in the temporal CSI image $H_c$ as the self-information image by inputting the temporal CSI image $H_c$ into a self-information module comprises:

> obtaining (601) split images $H_{c,i}$ at a plurality of time points by splitting the temporal CSI image $H_c$ according to a time sequence; and
> dividing (602) the split images into a plurality of areas to be estimated $p_j$, obtaining self-information estimation values $\hat{I}_j$ corresponding to the plurality of areas to be estimated, and generating a self-information image $I_{c,i}$ according to the self-information estimation values $\hat{I}_j$.

5. The method of claim 3 or 4, wherein the index matrix module comprises a mapping network and a judger, and obtaining (502) the first index matrix M by inputting the self-information image into the index matrix module for mapping comprises:

> obtaining (701) a first information feature image $D_{c,i}$ by inputting the self-information image into the mapping network for feature extraction, wherein the mapping network is a two-dimensional convolutional neural network;
> obtaining (702) a second index matrix $M_i$ by inputting the first information feature image $D_{c,i}$ into the judger for binarization; and
> obtaining (703) the first index matrix M by splicing the second index matrix $M_i$;
> optionally, wherein the mapping network comprises a two-dimensional convolutional layer, a two-dimensional normalization layer and an activation function layer, and inputting (701) the self-information image into the mapping network for feature extraction comprises:

>> obtaining (801) a first feature image by inputting the self-information image into the two-dimensional convolutional layer for feature extraction;
>> obtaining (802) a second feature image by inputting the first feature image into the two-dimensional normalization layer to normalize pixel values in the first feature image; and
>> obtaining (803) the first information feature image $D_{c,i}$ by inputting the second feature image into the activation function layer for nonlinear mapping; or
> wherein obtaining (703) the first index matrix M by splicing the second index matrix $M_i$ comprises:
> obtaining the first index matrix M by splicing the second index matrix $M_i$ in an order of a time sequence.

6. The method of any of claims 1-5, wherein the temporal feature coupling encoder comprises a one-dimensional time-space compression network and a coupling long short term memory network, LSTM
optionally, wherein generating (302) the structural feature matrix and the temporal correlation matrix by inputting the temporal self-information image $H_e$ into the temporal feature coupling encoder for feature extraction comprises:

> obtaining the structural feature matrix by inputting the temporal self-information image $H_e$ subjected to dimension transformation into the one-dimensional time-space compression network for one-dimensional time-space compression, wherein a convolution kernel specification of the one-dimensional time-space compression network is $S \times 2N_cN_t \times m$, $2N_cN_t$ represents a length of a convolution window, $m$ represents a width of the convolution window, S represents a target dimension, and a dimension of the structural feature matrix is $T \times S$; or
> obtaining (1001) the temporal correlation matrix by inputting the temporal self-information image $H_e$ subjected to

dimension transformation into a coupling LSTM for feature extraction, wherein a dimension of the temporal correlation matrix is T $\times$ S; and coupling (1002) the structural feature matrix and the temporal correlation matrix to generate the feature codeword.

7. The method of any one of claims 1-6, further comprising:

obtaining (1101) a training temporal self-information image $H_e$ by inputting a training temporal CSI image $H_c$ into a self-information domain transformer; and
obtaining (1102) a training feature codeword by inputting the training temporal self-information image $H_e$ into a temporal feature coupling encoder;
optionally, the method further comprising:
sending training data to the network device, wherein the training data comprises the training feature codeword, a time-sequence length of a temporal self-information image $H_e$, a dimension of the training feature codeword, and a training temporal CSI image $H_c$.

8. A channel state information, CSI, decompression feedback method, performed by a network device, comprising:

receiving (1201) a feature codeword sent by a terminal;
restoring (1202) the feature codeword to obtain a restored temporal CSI image $H_c$; and
obtaining (1203) an estimated CSI image $\hat{H}$ of the terminal according to the restored temporal CSI image $\hat{H}_c$;
**characterized in that** restoring (1202) the feature codeword comprises:

obtaining the restored temporal CSI image $\hat{H}_c$ by inputting the feature codeword into a temporal feature coupling decoder;
wherein the temporal feature coupling decoder comprises a decoupling module and a restoration convolutional neural network, obtaining the restored temporal CSI image $\hat{H}_c$ comprises:

obtaining (1301) a restored temporal self-information image $\hat{H}_e$ by inputting the feature codeword into the decoupling module for decoupling; and
obtaining (1302) the restored temporal CSI image $\hat{H}_c$ by inputting the restored temporal self-information image $\hat{H}_e$ into the restoration convolutional neural network for restoration.

9. The method of claim 8, wherein the decoupling module comprises a one-dimensional time-space decompression network and a decoupling long short term memory network, LSTM, obtaining (1301) the restored temporal self-information image by inputting the feature codeword into the decoupling module for decoupling comprises:

obtaining (1401) a restored structural feature matrix by inputting the feature codeword into the one-dimensional time-space decompression network for decompression;
obtaining (1402) a restored temporal correlation matrix by inputting the feature codeword into the decoupling LSTM for decoupling; and
obtaining (1403) the restored temporal self-information image $\hat{H}_e$ according to the restored structural feature matrix and the restored temporal correlation matrix;
optionally, wherein obtaining (1403) the restored temporal self-information image $\hat{H}_e$ according to the restored structural feature matrix and the restored temporal correlation matrix comprises:
adding the restored structural feature matrix and the restored temporal correlation matrix point by point and performing dimension transformation, to obtain the restored temporal self-information image $\hat{H}_e$.

10. The method of claim 8, wherein a convolution kernel specification of the one-dimensional time-space decompression network is $2N_cN_t \times S \times m$, $2N_cN_t$ represents a length of a convolution window, m represents a width of the convolution window, S represents a target dimension, and a dimension of the structural feature matrix is T $\times$ S.

11. The method of claim 8, wherein the restored convolution neural network comprises a first convolutional layer, a second convolutional layer, a third convolutional layer, a fourth convolutional layer, a fifth convolutional layer, a sixth convolutional layer, and a seventh convolutional layer, wherein a convolution kernel specification of the first convolutional layer and the fourth convolutional layer is $l_1 \times t \times n \times n$, a convolution kernel specification of the second convolutional layer and the fifth convolutional layer is $l_2 \times t \times n \times n$, and a convolution kernel specification of the third convolutional layer, the sixth convolutional layer and the seventh convolutional layer is $2 \times t \times n \times n$, t represents a convolution depth in a time dimension, $l_1$, $l_2$ and 2 are numbers of extracted features, and n represents a length and a width of a convolution window;
optionally, wherein obtaining (1302) the restored temporal CSI image $\hat{H}_c$ by inputting the restored temporal self-information image $\hat{H}_e$ into the restoration convolutional neural network for restoration comprises:

obtaining a first restored feature map by inputting the restored temporal self-information image $\hat{H}_e$ into the first convolutional layer for convolution, obtaining a second restored feature map by inputting the first restored feature map into the second convolutional layer, obtaining a third restored feature map by inputting the second restored feature map into the third convolutional layer, and obtaining a fourth restored feature map by adding the third restored feature map and the restored temporal self-information image $\hat{H}_e$;

obtaining a fifth restored feature map by inputting the fourth restored feature map into the fourth convolutional layer, obtaining a sixth restored feature map by inputting the fifth reduced feature map into the fifth convolutional layer, obtaining a seventh restored feature map by inputting the sixth restored feature map into the sixth convolutional layer, and obtaining an eighth restored feature map by adding the fourth restored feature map and the seventh restored feature map; and

obtaining the restored temporal CSI image $\hat{H}_c$ by inputting the eighth restored feature image into the seventh convolutional layer for normalization.

12. The method of any one of claims 8-11, further comprising:

receiving (1501) training data sent by the terminal, wherein the training data comprises a training feature codeword, a time-sequence length of a temporal self-information image $H_e$, a dimension of the training feature codeword, and a training temporal CSI image;
obtaining (1502) a restored temporal CSI image according to the training feature codeword; and
performing (1503) training according to the restored temporal CSI image and the training temporal CSI image.
optionally, the method further comprising at least one of:

determining (1601) a number of structural units in a decoupling LSTM according to the time-sequence length of the temporal self-information image $H_e$, and determining (1602) network parameters of a one-dimensional time-space decompression network according to the dimension of the training feature codeword;
performing multiple rounds of training, wherein an equation of a learning rate in the training is represented as:

$$\gamma = \gamma_{min} + \frac{1}{2}(\gamma_{max} + \gamma_{min})[1 + cos(\frac{t - T_w}{T' - T_w}\pi)],$$

where $\gamma$ represents a current learning rate, $\gamma_{max}$ represents a maximum learning rate, $\gamma_{min}$ represents a minimum learning rate, t represents a current number of training rounds, $T_w$ represents a number of gradual learnings, $T'$ represents a number of overall training cycles; or
obtaining recommended network parameters for a decoupling module and a restored convolutional neural network, and updating the decoupling module and the restored convolutional neural network according to the recommended network parameters.

13. A communication device, comprising:

an estimation module, configured to obtain an estimated channel state information, CSI image H of a network device, and generate a temporal CSI image $H_c$ according to the estimated CSI image H;
a compressing module, configured to compress the temporal CSI image $H_c$ to generate a feature codeword; and
a sending module, configured to send the feature codeword to the network device;
**characterized in that** the compressing module, is further configured to:

generate a temporal self-information image $\hat{H}_e$ by inputting the temporal CSI image $H_c$ into a self-information domain transformer, wherein a time dimension of both the temporal CSI image $H_c$ and the temporal self-information image $H_e$ is T;
generate a structural feature matrix and a temporal correlation matrix by inputting the temporal self-information image $H_e$ into a temporal feature coupling encoder for feature extraction; and
generate the feature codeword according to the structural feature matrix and the temporal correlation matrix.

14. A communication device, comprising:

a receiving module, configured to receive a feature codeword sent by a terminal;
a restoring module, configured to restore the feature codeword to obtain a restored temporal CSI image $\hat{H}_c$; and
a channel obtaining module, configured to obtain a restored estimated CSI image $\hat{H}$ according to the restored temporal CSI image $\hat{H}_c$;
**characterized in that** the restoring module, is further configured to:

obtain the restored temporal CSI image $\hat{H}_c$ by inputting the feature codeword into a temporal feature coupling decoder;
wherein the temporal feature coupling decoder comprises a decoupling module and a restoration convolutional neural network, obtaining the restored temporal CSI image $\hat{H}_c$ comprises:

obtaining (1301) a restored temporal self-information image $\hat{H}_e$ by inputting the feature codeword into the decoupling module for decoupling; and
obtaining (1302) the restored temporal CSI image $\hat{H}_c$ by inputting the restored temporal self-information image $\hat{H}_e$ into the restoration convolutional neural network for restoration.

**Patentansprüche**

1. Ein Kanalzustandsinformation, CSI, Kompressionsrückmeldungsverfahren, durchgeführt von einem Endgerät, umfassend:

Erhalten (201) eines geschätzten CSI-Bildes H einer Netzwerkvorrichtung und Erzeugen eines zeitlichen CSI-Bildes $H_c$ gemäß dem geschätzten CSI-Bild H;
Komprimieren (202) des zeitlichen CSI-Bildes $H_c$, um ein Merkmalscodewort zu erzeugen; und
Senden (203) des Merkmalscodeworts an die Netzwerkvorrichtung;
**dadurch gekennzeichnet, dass**
wobei das Komprimieren (202) des zeitlichen CSI-Bildes $H_c$, um das Merkmalscodewort zu erzeugen, umfasst:

Erzeugen (301) eines zeitlichen Selbstinformationsbildes $H_e$ durch Eingeben des zeitlichen CSI-Bildes $H_c$ in einen Selbstinformationsdomänentransformator, wobei eine Zeitdimension sowohl des zeitlichen CSI-Bildes $H_c$ als auch des zeitlichen Selbstinformationsbildes $H_e$ T ist;
Erzeugen (302) einer Strukturmerkmalsmatrix und einer zeitlichen Korrelationsmatrix durch Eingeben des zeitlichen Selbstinformationsbildes $H_e$ in einen zeitlichen Merkmalskopplungs-Codierer zur Merkmalsextraktion; und
Erzeugen (303) des Merkmalscodeworts gemäß der Strukturmerkmalsmatrix und der zeitlichen Korrelationsmatrix.

2. Das Verfahren nach Anspruch 1,
wobei das Erzeugen (301) des zeitlichen Selbstinformationsbildes $H_e$ durch Eingeben des zeitlichen CSI-Bildes $H_c$ in den Selbstinformationsdomänentransformator umfasst:

Erhalten (401) eines ersten zeitlichen Merkmalsbildes F durch Eingeben des zeitlichen CSI-Bildes $H_c$ in ein dreidimensionales Faltungsmerkmalsextraktionsnetzwerk zur Merkmalsextraktion, wobei eine Faltungskernspezifikation des dreidimensionalen Faltungsnetzwerks $f \times t \times n \times n$ ist, f eine Anzahl zu extrahierender Merkmale darstellt, t eine Faltungstiefe in einer Zeitdimension darstellt und n eine Länge und eine Breite eines Faltungsfensters darstellt;
Erzeugen (402) einer ersten Indexmatrix M gemäß dem zeitlichen CSI-Bild $H_c$; und
Erhalten (403) des zeitlichen Selbstinformationsbildes $H_e$ gemäß dem ersten zeitlichen Merkmalsbild F und der ersten Indexmatrix M.

3. Das Verfahren nach Anspruch 2, wobei das Erzeugen (402) der ersten Indexmatrix M gemäß dem zeitlichen CSI-Bild $H_c$ umfasst:

Erzeugen (501) einer Selbstinformation eines zu schätzenden Bereichs in dem zeitlichen CSI-Bild $H_c$ als ein Selbstinformationsbild durch Eingeben des zeitlichen CSI-Bildes $H_c$ in ein Selbstinformationsmodul; und
Erhalten (502) der ersten Indexmatrix M durch Eingeben des Selbstinformationsbildes in ein Indexmatrixmodul zum Abbilden; oder

wobei das Erhalten (403) des zeitlichen Selbstinformationsbildes $H_e$ gemäß dem ersten zeitlichen Merkmalsbild F und der ersten Indexmatrix M umfasst:

Erhalten (901) eines zweiten Informationsmerkmalsbildes durch Multiplizieren des ersten zeitlichen Merkmalsbildes F und der ersten Indexmatrix M; und

Erzeugen (902) des zeitlichen Selbstinformationsbildes $H_e$ durch Eingeben des zweiten Informationsmerkmalsbildes in ein Dimensionswiederherstellungsnetzwerk zur Dimensionswiederherstellung.

4. Das Verfahren nach Anspruch 3, wobei das Erzeugen (501) der Selbstinformation des zu schätzenden Bereichs in dem zeitlichen CSI-Bild $H_c$ als des Selbstinformationsbildes durch Eingeben des zeitlichen CSI-Bildes $H_c$ in ein Selbstinformationsmodul umfasst:

Erhalten (601) von Teilbildern $H_{c,i}$ an einer Vielzahl von Zeitpunkten durch Aufteilen des zeitlichen CSI-Bildes $H_c$ gemäß einer Zeitsequenz; und

Unterteilen (602) der Teilbilder in eine Vielzahl von zu schätzenden Bereichen $p_j$, Erhalten von Selbstinformationsschätzwerten $\hat{I}_j$ entsprechend der Vielzahl von zu schätzenden Bereichen und Erzeugen eines Selbstinformationsbildes $I_{c,i}$ gemäß den Selbstinformationsschätzwerten $\hat{I}_j$.

5. Das Verfahren nach Anspruch 3 oder 4, wobei das Indexmatrixmodul ein Abbildungsnetzwerk und einen Entscheider umfasst und das Erhalten (502) der ersten Indexmatrix M durch Eingeben des Selbstinformationsbildes in das Indexmatrixmodul zum Abbilden umfasst:

Erhalten (701) eines ersten Informationsmerkmalsbildes $D_{c,i}$ durch Eingeben des Selbstinformationsbildes in das Abbildungsnetzwerk zur Merkmalsextraktion, wobei das Abbildungsnetzwerk ein zweidimensionales Faltungsneuronales Netzwerk ist;

Erhalten (702) einer zweiten Indexmatrix $M_i$ durch Eingeben des ersten Informationsmerkmalsbildes $D_{c,}$i in den Entscheider zur Binärisierung; und

Erhalten (703) der ersten Indexmatrix M durch Spleißen der zweiten Indexmatrix $M_i$;

wahlweise, wobei das Abbildungsnetzwerk eine zweidimensionale Faltungsschicht, eine zweidimensionale Normalisierungsschicht und eine Aktivierungsfunktionsschicht umfasst und das Eingeben (701) des Selbstinformationsbildes in das Abbildungsnetzwerk zur Merkmalsextraktion umfasst:

Erhalten (801) eines ersten Merkmalsbildes durch Eingeben des Selbstinformationsbildes in die zweidimensionale Faltungsschicht zur Merkmalsextraktion;

Erhalten (802) eines zweiten Merkmalsbildes durch Eingeben des ersten Merkmalsbildes in die zweidimensionale Normalisierungsschicht, um Pixelwerte in dem ersten Merkmalsbild zu normalisieren; und

Erhalten (803) des ersten Informationsmerkmalsbildes $D_{c,i}$ durch Eingeben des zweiten Merkmalsbildes in die Aktivierungsfunktionsschicht zur nichtlinearen Abbildung; oder

wobei das Erhalten (703) der ersten Indexmatrix M durch Spleißen der zweiten Indexmatrix $M_i$ umfasst:

Erhalten der ersten Indexmatrix M durch Spleißen der zweiten Indexmatrix $M_i$ in einer Reihenfolge einer Zeitsequenz.

6. Das Verfahren nach einem der Ansprüche 1-5, wobei der zeitliche Merkmalskopplungs-Codierer ein eindimensionales Zeit-Raum-Kompressionsnetzwerk und ein gekoppelte(s) Long-Short-Term-Memory-Netzwerk, LSTM, umfasst

wahlweise, wobei das Erzeugen (302) der Strukturmerkmalsmatrix und der zeitlichen Korrelationsmatrix durch Eingeben des zeitlichen Selbstinformationsbildes $H_e$ in den zeitlichen Merkmalskopplungs-Codierer zur Merkmalsextraktion umfasst:

Erhalten der Strukturmerkmalsmatrix durch Eingeben des einer Dimensionstransformation unterzogenen zeitlichen Selbstinformationsbildes $H_e$ in das eindimensionale Zeit-Raum-Kompressionsnetzwerk zur eindimensionalen Zeit-Raum-Kompression, wobei eine Faltungskernspezifikation des eindimensionalen Zeit-Raum-Kompressionsnetzwerks $S \times 2N_c\,N_t \times m$ ist, $2N_c\,N_t$ eine Länge eines Faltungsfensters darstellt, m eine Breite des Faltungsfensters darstellt, S eine Zieldimension darstellt und eine Dimension der Strukturmerkmalsmatrix $T \times S$ ist; oder

Erhalten (1001) der zeitlichen Korrelationsmatrix durch Eingeben des einer Dimensionstransformation unterzogenen zeitlichen Selbstinformationsbildes $H_e$ in ein gekoppeltes LSTM zur Merkmalsextraktion, wobei eine Dimension der zeitlichen Korrelationsmatrix $T \times S$ ist; und Koppeln (1002) der Strukturmerkmalsmatrix und der zeitlichen Korrelationsmatrix, um das Merkmalscodewort zu erzeugen.

7. Das Verfahren nach einem der Ansprüche 1-6, ferner umfassend:

Erhalten (1101) eines Trainings-Selbstinformationsbildes $H_e$ durch Eingeben eines Trainings-zeitlichen CSI-Bildes $H_c$ in einen Selbstinformationsdomänentransformator; und
Erhalten (1102) eines Trainings-Merkmalscodeworts durch Eingeben des Trainings-zeitlichen Selbstinformationsbildes $H_e$ in einen zeitlichen Merkmalskopplungs-Codierer;
wahlweise ferner umfassend:
Senden von Trainingsdaten an die Netzwerkvorrichtung, wobei die Trainingsdaten das Trainings-Merkmalscodewort, eine Zeitsequenzlänge eines zeitlichen Selbstinformationsbildes $H_e$, eine Dimension des Trainings-Merkmalscodeworts und ein Trainings-zeitliches CSI-Bild $H_c$ umfassen.

8. Ein Kanalzustandsinformation, CSI, Dekompressionsrückmeldungsverfahren, durchgeführt von einer Netzwerkvorrichtung, umfassend:

Empfangen (1201) eines von einem Endgerät gesendeten Merkmalscodeworts;
Wiederherstellen (1202) des Merkmalscodeworts, um ein wiederhergestelltes zeitliches CSI-Bild $H_c$ zu erhalten; und
Erhalten (1203) eines geschätzten CSI-Bildes $\hat{H}$ des Endgeräts gemäß dem wiederhergestellten zeitlichen CSI-Bild $\hat{H}_c$;
**dadurch gekennzeichnet, dass**
wobei das Wiederherstellen (1202) des Merkmalscodeworts umfasst:

Erhalten des wiederhergestellten zeitlichen CSI-Bildes $\hat{H}_c$ durch Eingeben des Merkmalscodeworts in einen zeitlichen Merkmalskopplungs-Decodierer;
wobei der zeitliche Merkmalskopplungs-Decodierer ein Entkopplungsmodul und ein Wiederherstellungs-Faltungsneuronales Netzwerk umfasst, wobei das Erhalten des wiederhergestellten zeitlichen CSI-Bildes $\hat{H}_c$ umfasst:

Erhalten (1301) eines wiederhergestellten zeitlichen Selbstinformationsbildes $\hat{H}_e$ durch Eingeben des Merkmalscodeworts in das Entkopplungsmodul zur Entkopplung; und
Erhalten (1302) des wiederhergestellten zeitlichen CSI-Bildes $\hat{H}_c$ durch Eingeben des wiederhergestellten zeitlichen Selbstinformationsbildes $\hat{H}_e$ in das Wiederherstellungs-Faltungsneuronale Netzwerk zur Wiederherstellung.

9. Das Verfahren nach Anspruch 8, wobei das Entkopplungsmodul ein eindimensionales Zeit-Raum-Dekompressionsnetzwerk und ein Entkopplungs-Long-Short-Term-Memory-Netzwerk, LSTM, umfasst, wobei das Erhalten (1301) des wiederhergestellten zeitlichen Selbstinformationsbildes durch Eingeben des Merkmalscodeworts in das Entkopplungsmodul zur Entkopplung umfasst:

Erhalten (1401) einer wiederhergestellten Strukturmerkmalsmatrix durch Eingeben des Merkmalscodeworts in das eindimensionale Zeit-Raum-Dekompressionsnetzwerk zur Dekompression;
Erhalten (1402) einer wiederhergestellten zeitlichen Korrelationsmatrix durch Eingeben des Merkmalscodeworts in das Entkopplungs-LSTM zur Entkopplung; und
Erhalten (1403) des wiederhergestellten zeitlichen Selbstinformationsbildes $\hat{H}\_e$ gemäß der wiederhergestellten Strukturmerkmalsmatrix und der wiederhergestellten zeitlichen Korrelationsmatrix;
wahlweise, wobei das Erhalten (1403) des wiederhergestellten zeitlichen Selbstinformationsbildes $\hat{H}_e$ gemäß der wiederhergestellten Strukturmerkmalsmatrix und der wiederhergestellten zeitlichen Korrelationsmatrix umfasst:
punktweises Addieren der wiederhergestellten Strukturmerkmalsmatrix und der wiederhergestellten zeitlichen Korrelationsmatrix und Durchführen einer Dimensionstransformation, um das wiederhergestellte zeitliche Selbstinformationsbild $\hat{H}_e$ zu erhalten.

10. Das Verfahren nach Anspruch 8, wobei eine Faltungskernspezifikation des eindimensionalen Zeit-Raum-Dekompressionsnetzwerks $2N_c N_t \times S \times m$ ist, $2N_c N_t$ eine Länge eines Faltungsfensters darstellt, m eine Breite des Faltungsfensters darstellt, S eine Zieldimension darstellt und eine Dimension der Strukturmerkmalsmatrix $T \times S$ ist.

11. Das Verfahren nach Anspruch 8, wobei das wiederhergestellte Faltungsneuronale Netzwerk eine erste Faltungsschicht, eine zweite Faltungsschicht, eine dritte Faltungsschicht, eine vierte Faltungsschicht, eine fünfte Faltungsschicht, eine sechste Faltungsschicht und eine siebte Faltungsschicht umfasst, wobei eine Faltungskernspezifikation der ersten Faltungsschicht und der vierten Faltungsschicht $l_1 \times t \times n \times n$ ist, eine Faltungskernspezifikation der zweiten Faltungsschicht und der fünften Faltungsschicht $l_2 \times t \times n \times n$ ist und eine Faltungskernspezifikation der dritten Faltungsschicht, der sechsten Faltungsschicht und der siebten Faltungsschicht $2 \times t \times n \times n$ ist, t eine Faltungstiefe in einer Zeitdimension darstellt, $l_1$, $l_2$ und 2 Anzahlen extrahierter Merkmale sind und n eine Länge und eine Breite eines Faltungsfensters darstellt;

wahlweise, wobei das Erhalten (1302) des wiederhergestellten zeitlichen CSI-Bildes $\hat{H}_c$ durch Eingeben des wiederhergestellten zeitlichen Selbstinformationsbildes $\hat{H}_e$ in das Wiederherstellungs-Faltungsneuronale Netzwerk zur Wiederherstellung umfasst:

Erhalten einer ersten wiederhergestellten Merkmalsabbildung durch Eingeben des wiederhergestellten zeitlichen Selbstinformationsbildes $\hat{H}_e$ in die erste Faltungsschicht zur Faltung, Erhalten einer zweiten wiederhergestellten Merkmalsabbildung durch Eingeben der ersten wiederhergestellten Merkmalsabbildung in die zweite Faltungsschicht, Erhalten einer dritten wiederhergestellten Merkmalsabbildung durch Eingeben der zweiten wiederhergestellten Merkmalsabbildung in die dritte Faltungsschicht und Erhalten einer vierten wiederhergestellten Merkmalsabbildung durch Addieren der dritten wiederhergestellten Merkmalsabbildung und des wiederhergestellten zeitlichen Selbstinformationsbildes $\hat{H}_e$;

Erhalten einer fünften wiederhergestellten Merkmalsabbildung durch Eingeben der vierten wiederhergestellten Merkmalsabbildung in die vierte Faltungsschicht, Erhalten einer sechsten wiederhergestellten Merkmalsabbildung durch Eingeben der fünften reduzierten Merkmalsabbildung in die fünfte Faltungsschicht, Erhalten einer siebten wiederhergestellten Merkmalsabbildung durch Eingeben der sechsten wiederhergestellten Merkmalsabbildung in die sechste Faltungsschicht und Erhalten einer achten wiederhergestellten Merkmalsabbildung durch Addieren der vierten wiederhergestellten Merkmalsabbildung und der siebten wiederhergestellten Merkmalsabbildung; und

Erhalten des wiederhergestellten zeitlichen CSI-Bildes $\hat{H}_c$ durch Eingeben des achten wiederhergestellten Merkmalsbildes in die siebte Faltungsschicht zur Normalisierung.

12. Das Verfahren nach einem der Ansprüche 8-11, ferner umfassend:

Empfangen (1501) von von dem Endgerät gesendeten Trainingsdaten, wobei die Trainingsdaten ein Trainings-Merkmalscodewort, eine Zeitsequenzlänge eines zeitlichen Selbstinformationsbildes $H_e$, eine Dimension des Trainings-Merkmalscodeworts und ein Trainings-zeitliches CSI-Bild umfassen;

Erhalten (1502) eines wiederhergestellten zeitlichen CSI-Bildes gemäß dem Trainings-Merkmalscodewort; und Durchführen (1503) eines Trainings gemäß dem wiederhergestellten zeitlichen CSI-Bild und dem Trainings-zeitlichen CSI-Bild.

wahlweise, ferner umfassend mindestens eines von:

Bestimmen (1601) einer Anzahl von Struktureinheiten in einem Entkopplungs-LSTM gemäß der Zeitsequenzlänge des zeitlichen Selbstinformationsbildes H_e und Bestimmen (1602) von Netzwerkparametern eines eindimensionalen Zeit-Raum-Dekompressionsnetzwerks gemäß der Dimension des Trainings-Merkmalscodeworts;

Durchführen mehrerer Trainingsrunden, wobei eine Gleichung einer Lernrate in dem Training dargestellt ist als:

$$\gamma = \gamma_{min} + \frac{1}{2}(\gamma_{max} + \gamma_{min})[1 + cos(\frac{t - T_w}{T' - T_w}\pi)],$$

wobei $\gamma$ eine aktuelle Lernrate darstellt, $\gamma_{max}$ eine maximale Lernrate darstellt, $\gamma_{min}$ eine minimale Lernrate darstellt, t eine aktuelle Anzahl von Trainingsrunden darstellt, $T_w$ eine Anzahl allmählicher Lernvorgänge darstellt, T' eine Anzahl gesamter Trainingszyklen darstellt; oder

Erhalten empfohlener Netzwerkparameter für ein Entkopplungsmodul und ein wiederhergestelltes Faltungsneuronales Netzwerk und Aktualisieren des Entkopplungsmoduls und des wiederhergestellten Faltungsneuronalen Netzwerks gemäß den empfohlenen Netzwerkparametern.

13. Eine Kommunikationsvorrichtung, umfassend:

ein Schätzmodul, konfiguriert zum Erhalten eines geschätzten Kanalzustandsinformation, CSI, Bildes H einer Netzwerkvorrichtung und zum Erzeugen eines zeitlichen CSI-Bildes $H_c$ gemäß dem geschätzten CSI-Bild H;

ein Komprimiermodul, konfiguriert zum Komprimieren des zeitlichen CSI-Bildes $H_c$, um ein Merkmalscodewort zu erzeugen; und

ein Sendemodul, konfiguriert zum Senden des Merkmalscodeworts an die Netzwerkvorrichtung;

**dadurch gekennzeichnet, dass** das Komprimiermodul ferner konfiguriert ist zum:

Erzeugen eines zeitlichen Selbstinformationsbildes $H_e$ durch Eingeben des zeitlichen CSI-Bildes $H_c$ in einen Selbstinformationsdomänentransformator, wobei eine Zeitdimension sowohl des zeitlichen CSI-Bildes $H_c$ als auch des zeitlichen Selbstinformationsbildes $H_e$ T ist;

Erzeugen einer Strukturmerkmalsmatrix und einer zeitlichen Korrelationsmatrix durch Eingeben des zeitlichen Selbstinformationsbildes $H_e$ in einen zeitlichen Merkmalskopplungs-Codierer zur Merkmalsextraktion; und

Erzeugen des Merkmalscodeworts gemäß der Strukturmerkmalsmatrix und der zeitlichen Korrelationsmatrix.

**14.** Eine Kommunikationsvorrichtung, umfassend:

ein Empfangsmodul, konfiguriert zum Empfangen eines von einem Endgerät gesendeten Merkmalscodeworts;

ein Wiederherstellungsmodul, konfiguriert zum Wiederherstellen des Merkmalscodeworts, um ein wiederhergestelltes zeitliches CSI-Bild $H_c$ zu erhalten; und

ein Kanalerhaltsmodul, konfiguriert zum Erhalten eines wiederhergestellten geschätzten CSI-Bildes $\hat{H}$ gemäß dem wiederhergestellten zeitlichen CSI-Bild $\hat{H}_c$;

**dadurch gekennzeichnet, dass** das Wiederherstellungsmodul ferner konfiguriert ist zum:

Erhalten des wiederhergestellten zeitlichen CSI-Bildes $\hat{H}_c$ durch Eingeben des Merkmalscodeworts in einen zeitlichen Merkmalskopplungs-Decodierer;

wobei der zeitliche Merkmalskopplungs-Decodierer ein Entkopplungsmodul und ein Wiederherstellungs-Faltungsneuronales Netzwerk umfasst, wobei das Erhalten des wiederhergestellten zeitlichen CSI-Bildes $\hat{H}_c$ umfasst:

Erhalten (1301) eines wiederhergestellten zeitlichen Selbstinformationsbildes $\hat{H}_e$ durch Eingeben des Merkmalscodeworts in das Entkopplungsmodul zur Entkopplung; und

Erhalten (1302) des wiederhergestellten zeitlichen CSI-Bildes $\hat{H}_c$ durch Eingeben des wiederhergestellten zeitlichen Selbstinformationsbildes $\hat{H}_e$ in das Wiederherstellungs-Faltungsneuronale Netzwerk zur Wiederherstellung.

## Revendications

**1.** Procédé de retour d'information de compression d'informations d'état de canal, CSI, mis en œuvre par un terminal, comprenant :

l'obtention (201) d'une image CSI estimée H d'un dispositif réseau, et la génération d'une image CSI temporelle $H_c$ selon l'image CSI estimée H ;

la compression (202) de l'image CSI temporelle $H_c$ pour générer un mot de code de caractéristiques ; et

l'envoi (203) du mot de code de caractéristiques au dispositif réseau ;

**caractérisé en ce que**

dans lequel la compression (202) de l'image CSI temporelle $H_c$ pour générer le mot de code de caractéristiques comprend :

la génération (301) d'une image d'auto-information temporelle $H_e$ par entrée de l'image CSI temporelle $H_c$ dans un transformateur de domaine d'auto-information, dans lequel une dimension temporelle de l'image CSI temporelle $H_c$ et de l'image d'auto-information temporelle $H_e$ est T ;

la génération (302) d'une matrice de caractéristiques structurelles et d'une matrice de corrélation temporelle par entrée de l'image d'auto-information temporelle $H_e$ dans un encodeur de couplage de caractéristiques temporelles pour l'extraction de caractéristiques ; et

la génération (303) du mot de code de caractéristiques selon la matrice de caractéristiques structurelles et la matrice de corrélation temporelle.

**2.** Procédé selon la revendication 1,
dans lequel la génération (301) de l'image d'auto-information temporelle $H_e$ par entrée de l'image CSI temporelle $H_c$ dans le transformateur de domaine d'auto-information comprend :

l'obtention (401) d'une première image de caractéristiques temporelles F par entrée de l'image CSI temporelle $H_c$ dans un réseau tridimensionnel de convolution d'extraction de caractéristiques pour l'extraction de caractéristiques, dans lequel une spécification de noyau de convolution du réseau tridimensionnel de convolution est $f \times t \times n \times n$, f représente un nombre de caractéristiques à extraire, t représente une profondeur de convolution dans une dimension temporelle, et n représente une longueur et une largeur d'une fenêtre de convolution ;
la génération (402) d'une première matrice d'indices M selon l'image CSI temporelle $H_c$ ; et
l'obtention (403) de l'image d'auto-information temporelle $H_e$ selon la première image de caractéristiques temporelles F et la première matrice d'indices M.

**3.** Procédé selon la revendication 2, dans lequel la génération (402) de la première matrice d'indices M selon l'image CSI temporelle $H_c$ comprend :

la génération (501) d'une auto-information d'une zone à estimer dans l'image CSI temporelle $H_c$ en tant qu'image d'auto-information par entrée de l'image CSI temporelle $H_c$ dans un module d'auto-information ; et
l'obtention (502) de la première matrice d'indices M par entrée de l'image d'auto-information dans un module de matrice d'indices pour le mappage ; ou
dans lequel l'obtention (403) de l'image d'auto-information temporelle $H_e$ selon la première image de caractéristiques temporelles F et la première matrice d'indices M comprend :

l'obtention (901) d'une seconde image de caractéristiques d'information par multiplication de la première image de caractéristiques temporelles F et de la première matrice d'indices M ; et
la génération (902) de l'image d'auto-information temporelle $H_e$ par entrée de la seconde image de caractéristiques d'information dans un réseau de restauration de dimension pour une restauration de dimension.

**4.** Procédé selon la revendication 3, dans lequel la génération (501) de l'auto-information de la zone à estimer dans l'image CSI temporelle $H_c$ en tant qu'image d'auto-information par entrée de l'image CSI temporelle $H_c$ dans un module d'auto-information comprend :

l'obtention (601) d'images divisées $H_{c,i}$ à une pluralité de points temporels par division de l'image CSI temporelle $H_c$ selon une séquence temporelle ; et
la division (602) des images divisées en une pluralité de zones à estimer $p_j$, l'obtention de valeurs d'estimation d'auto-information $\hat{I}_j$ correspondant à la pluralité de zones à estimer, et la génération d'une image d'auto-information $I_{c,i}$ selon les valeurs d'estimation d'auto-information $\hat{I}_j$.

**5.** Procédé selon la revendication 3 ou 4, dans lequel le module de matrice d'indices comprend un réseau de mappage et un juge, et l'obtention (502) de la première matrice d'indices M par entrée de l'image d'auto-information dans le module de matrice d'indices pour le mappage comprend :

l'obtention (701) d'une première image de caractéristiques d'information $D_{c,i}$ par entrée de l'image d'auto-information dans le réseau de mappage pour l'extraction de caractéristiques, dans lequel le réseau de mappage est un réseau neuronal convolutif bidimensionnel ;
l'obtention (702) d'une seconde matrice d'indices $M_i$ par entrée de la première image de caractéristiques d'information $D_{c,i}$ dans le juge pour une binarisation ; et
l'obtention (703) de la première matrice d'indices M par épissage de la seconde matrice d'indices $M_i$ ;
optionnellement, dans lequel le réseau de mappage comprend une couche de convolution bidimensionnelle, une couche de normalisation bidimensionnelle et une couche de fonction d'activation, et l'entrée (701) de l'image d'auto-information dans le réseau de mappage pour l'extraction de caractéristiques comprend :

l'obtention (801) d'une première image de caractéristiques par entrée de l'image d'auto-information dans la couche de convolution bidimensionnelle pour l'extraction de caractéristiques ;
l'obtention (802) d'une seconde image de caractéristiques par entrée de la première image de caractéristiques dans la couche de normalisation bidimensionnelle pour normaliser des valeurs de pixel dans la première image de caractéristiques ; et

l'obtention (803) de la première image de caractéristiques d'information $D_{c,i}$ par entrée de la seconde image de caractéristiques dans la couche de fonction d'activation pour un mappage non linéaire ; ou

dans lequel l'obtention (703) de la première matrice d'indices M par épissage de la seconde matrice d'indices $M_i$ comprend :

l'obtention de la première matrice d'indices M par épissage de la seconde matrice d'indices $M_i$ dans un ordre d'une séquence temporelle.

6. Procédé selon l'une quelconque des revendications 1 à 5, dans lequel l'encodeur de couplage de caractéristiques temporelles comprend un réseau unidimensionnel de compression spatio-temporelle et un réseau de mémoire longue à court terme de couplage, LSTM

optionnellement, dans lequel la génération (302) de la matrice de caractéristiques structurelles et de la matrice de corrélation temporelle par entrée de l'image d'auto-information temporelle $H_e$ dans l'encodeur de couplage de caractéristiques temporelles pour l'extraction de caractéristiques comprend :

l'obtention de la matrice de caractéristiques structurelles par entrée de l'image d'auto-information temporelle $H_e$ soumise à une transformation de dimension dans le réseau unidimensionnel de compression spatio-temporelle pour une compression spatio-temporelle unidimensionnelle, dans lequel une spécification de noyau de convolution du réseau unidimensionnel de compression spatio-temporelle est $S \times 2N_cN_t \times m$, $2N_cN_t$ représente une longueur d'une fenêtre de convolution, m représente une largeur de la fenêtre de convolution, S représente une dimension cible, et une dimension de la matrice de caractéristiques structurelles est $T \times S$ ; ou

l'obtention (1001) de la matrice de corrélation temporelle par entrée de l'image d'auto-information temporelle $H_e$ soumise à une transformation de dimension dans un LSTM de couplage pour l'extraction de caractéristiques, dans lequel une dimension de la matrice de corrélation temporelle est $T \times S$ ; et le couplage (1002) de la matrice de caractéristiques structurelles et de la matrice de corrélation temporelle pour générer le mot de code de caractéristiques.

7. Procédé selon l'une quelconque des revendications 1 à 6, comprenant en outre :

l'obtention (1101) d'une image d'auto-information temporelle d'apprentissage $H_e$ par entrée d'une image CSI temporelle d'apprentissage $H_c$ dans un transformateur de domaine d'auto-information ; et

l'obtention (1102) d'un mot de code de caractéristiques d'apprentissage par entrée de l'image d'auto-information temporelle d'apprentissage $H_e$ dans un encodeur de couplage de caractéristiques temporelles ;

optionnellement, le procédé comprenant en outre :

l'envoi de données d'apprentissage au dispositif réseau, dans lequel les données d'apprentissage comprennent le mot de code de caractéristiques d'apprentissage, une longueur de séquence temporelle d'une image d'auto-information temporelle $H_e$, une dimension du mot de code de caractéristiques d'apprentissage, et une image CSI temporelle d'apprentissage $H_c$.

8. Procédé de retour d'information de décompression d'informations d'état de canal, CSI, mis en œuvre par un dispositif réseau, comprenant :

la réception (1201) d'un mot de code de caractéristiques envoyé par un terminal ;

la restauration (1202) du mot de code de caractéristiques pour obtenir une image CSI temporelle restaurée $H_c$ ; et

l'obtention (1203) d'une image CSI estimée Ĥ du terminal selon l'image CSI temporelle restaurée $\hat{H}_c$ ;

**caractérisé en ce que**

dans lequel la restauration (1202) du mot de code de caractéristiques comprend :

l'obtention de l'image CSI temporelle restaurée $\hat{H}_c$ par entrée du mot de code de caractéristiques dans un décodeur de couplage de caractéristiques temporelles ;

dans lequel le décodeur de couplage de caractéristiques temporelles comprend un module de découplage et un réseau neuronal convolutif de restauration, l'obtention de l'image CSI temporelle restaurée $\hat{H}_c$ comprenant :

l'obtention (1301) d'une image d'auto-information temporelle restaurée $\hat{H}_e$ par entrée du mot de code de caractéristiques dans le module de découplage pour le découplage ; et

l'obtention (1302) de l'image CSI temporelle restaurée $\hat{H}_c$ par entrée de l'image d'auto-information temporelle restaurée $\hat{H}_e$ dans le réseau neuronal convolutif de restauration pour la restauration.

9. Procédé selon la revendication 8, dans lequel le module de découplage comprend un réseau unidimensionnel de décompression spatio-temporelle et un réseau de mémoire longue à court terme de découplage, LSTM, l'obtention (1301) de l'image d'auto-information temporelle restaurée par entrée du mot de code de caractéristiques dans le module de découplage pour le découplage comprenant :

l'obtention (1401) d'une matrice de caractéristiques structurelles restaurée par entrée du mot de code de caractéristiques dans le réseau unidimensionnel de décompression spatio-temporelle pour la décompression ; l'obtention (1402) d'une matrice de corrélation temporelle restaurée par entrée du mot de code de caractéristiques dans le LSTM de découplage pour le découplage ; et l'obtention (1403) de l'image d'auto-information temporelle restaurée $\hat{H}_e$ selon la matrice de caractéristiques structurelles restaurée et la matrice de corrélation temporelle restaurée ; optionnellement, dans lequel l'obtention (1403) de l'image d'auto-information temporelle restaurée $\hat{H}_e$ selon la matrice de caractéristiques structurelles restaurée et la matrice de corrélation temporelle restaurée comprend : l'addition point par point de la matrice de caractéristiques structurelles restaurée et de la matrice de corrélation temporelle restaurée et l'exécution d'une transformation de dimension, pour obtenir l'image d'auto-information temporelle restaurée $\hat{H}_e$.

10. Procédé selon la revendication 8, dans lequel une spécification de noyau de convolution du réseau unidimensionnel de décompression spatio-temporelle est $2N_cN_t \times S \times m$, $2N_cN_t$ représente une longueur d'une fenêtre de convolution, m représente une largeur de la fenêtre de convolution, S représente une dimension cible, et une dimension de la matrice de caractéristiques structurelles est $T \times S$.

11. Procédé selon la revendication 8, dans lequel le réseau neuronal convolutif restauré comprend une première couche convolutive, une seconde couche convolutive, une troisième couche convolutive, une quatrième couche convolutive, une cinquième couche convolutive, une sixième couche convolutive, et une septième couche convolutive, dans lequel une spécification de noyau de convolution de la première couche convolutive et de la quatrième couche convolutive est $l_1 \times t \times n \times n$, une spécification de noyau de convolution de la seconde couche convolutive et de la cinquième couche convolutive est $l_2 \times t \times n \times n$, et une spécification de noyau de convolution de la troisième couche convolutive, de la sixième couche convolutive et de la septième couche convolutive est $2 \times t \times n \times n$, t représente une profondeur de convolution dans une dimension temporelle, $l_1$, $l_2$ et 2 sont des nombres de caractéristiques extraites, et n représente une longueur et une largeur d'une fenêtre de convolution ; optionnellement, dans lequel l'obtention (1302) de l'image CSI temporelle restaurée $\hat{H}_c$ par entrée de l'image d'auto-information temporelle restaurée $\hat{H}_e$ dans le réseau neuronal convolutif de restauration pour la restauration comprend :

l'obtention d'une première carte de caractéristiques restaurée par entrée de l'image d'auto-information temporelle restaurée $\hat{H}_e$ dans la première couche convolutive pour une convolution, l'obtention d'une seconde carte de caractéristiques restaurée par entrée de la première carte de caractéristiques restaurée dans la seconde couche convolutive, l'obtention d'une troisième carte de caractéristiques restaurée par entrée de la seconde carte de caractéristiques restaurée dans la troisième couche convolutive, et l'obtention d'une quatrième carte de caractéristiques restaurée par addition de la troisième carte de caractéristiques restaurée et de l'image d'auto-information temporelle restaurée $\hat{H}_e$ ; l'obtention d'une cinquième carte de caractéristiques restaurée par entrée de la quatrième carte de caractéristiques restaurée dans la quatrième couche convolutive, l'obtention d'une sixième carte de caractéristiques restaurée par entrée de la cinquième carte de caractéristiques réduite dans la cinquième couche convolutive, l'obtention d'une septième carte de caractéristiques restaurée par entrée de la sixième carte de caractéristiques restaurée dans la sixième couche convolutive, et l'obtention d'une huitième carte de caractéristiques restaurée par addition de la quatrième carte de caractéristiques restaurée et de la septième carte de caractéristiques restaurée ; et l'obtention de l'image CSI temporelle restaurée $\hat{H}_c$ par entrée de la huitième image de caractéristiques restaurée dans la septième couche convolutive pour une normalisation.

12. Procédé selon l'une quelconque des revendications 8 à 11, comprenant en outre :

la réception (1501) de données d'apprentissage envoyées par le terminal, dans lequel les données d'apprentissage comprennent un mot de code de caractéristiques d'apprentissage, une longueur de séquence temporelle d'une image d'auto-information temporelle $H_e$, une dimension du mot de code de caractéristiques d'apprentissage, et une image CSI temporelle d'apprentissage ;

l'obtention (1502) d'une image CSI temporelle restaurée selon le mot de code de caractéristiques d'apprentissage ; et

l'exécution (1503) d'un apprentissage selon l'image CSI temporelle restaurée et l'image CSI temporelle d'apprentissage.

optionnellement, le procédé comprenant en outre au moins l'un parmi :

la détermination (1601) d'un nombre d'unités structurelles dans un LSTM de découplage selon la longueur de séquence temporelle de l'image d'auto-information temporelle $H_e$, et la détermination (1602) de paramètres de réseau d'un réseau unidimensionnel de décompression spatio-temporelle selon la dimension du mot de code de caractéristiques d'apprentissage ;

l'exécution de multiples tours d'apprentissage, dans lequel une équation d'un taux d'apprentissage dans l'apprentissage est représentée comme suit :

$$\gamma = \gamma_{min} + \frac{1}{2}(\gamma_{max} + \gamma_{min})[1 + cos(\frac{t-T_w}{T'-T_w}\pi)],$$

dans laquelle $\gamma$ représente un taux d'apprentissage actuel, $\gamma_{max}$ représente un taux d'apprentissage maximal, $\gamma_{min}$ représente un taux d'apprentissage minimal, t représente un nombre actuel de tours d'apprentissage, $T_w$ représente un nombre d'apprentissages graduels, T' représente un nombre de cycles d'apprentissage globaux ; ou

l'obtention de paramètres de réseau recommandés pour un module de découplage et un réseau neuronal convolutif restauré, et la mise à jour du module de découplage et du réseau neuronal convolutif restauré selon les paramètres de réseau recommandés.

**13.** Dispositif de communication, comprenant :

un module d'estimation, configuré pour obtenir une image H CSI estimée d'informations d'état de canal, CSI, d'un dispositif réseau, et générer une image CSI temporelle $H_c$ selon l'image CSI estimée H ;

un module de compression, configuré pour comprimer l'image CSI temporelle $H_c$ afin de générer un mot de code de caractéristiques ; et

un module d'envoi, configuré pour envoyer le mot de code de caractéristiques au dispositif réseau ;

**caractérisé en ce que** le module de compression, est en outre configuré pour :

générer une image d'auto-information temporelle $H_e$ par entrée de l'image CSI temporelle $H_c$ dans un transformateur de domaine d'auto-information, dans lequel une dimension temporelle de l'image CSI temporelle $H_c$ et de l'image d'auto-information temporelle $H_e$ est T ;

générer une matrice de caractéristiques structurelles et une matrice de corrélation temporelle par entrée de l'image d'auto-information temporelle $H_e$ dans un encodeur de couplage de caractéristiques temporelles pour l'extraction de caractéristiques ; et

générer le mot de code de caractéristiques selon la matrice de caractéristiques structurelles et la matrice de corrélation temporelle.

**14.** Dispositif de communication, comprenant :

un module de réception, configuré pour recevoir un mot de code de caractéristiques envoyé par un terminal ;

un module de restauration, configuré pour restaurer le mot de code de caractéristiques pour obtenir une image CSI temporelle restaurée $H_c$ ; et

un module d'obtention de canal, configuré pour obtenir une image CSI estimée restaurée H selon l'image CSI temporelle restaurée $\hat{H}_c$ ;

**caractérisé en ce que** le module de restauration, est en outre configuré pour :

obtenir l'image CSI temporelle restaurée $\hat{H}_c$ par entrée du mot de code de caractéristiques dans un décodeur de couplage de caractéristiques temporelles ;

dans lequel le décodeur de couplage de caractéristiques temporelles comprend un module de découplage et un réseau neuronal convolutif de restauration, l'obtention de l'image CSI temporelle restaurée $\hat{H}_c$ comprenant :

l'obtention (1301) d'une image d'auto-information temporelle restaurée $\hat{H}_e$ par entrée du mot de code de caractéristiques dans le module de découplage pour le découplage ; et

l'obtention (1302) de l'image CSI temporelle restaurée $\hat{H}_c$ par entrée de l'image d'auto-information temporelle restaurée $\hat{H}_e$ dans le réseau neuronal convolutif de restauration pour la restauration.

101

network device

102

terminal device

FIG. 1

---

obtaining an estimated CSI image H of a network device, and generating a temporal CSI image Hc according to the estimated CSI image H — 201

compressing the temporal CSI image Hc to generate a feature codeword — 202

sending the feature codeword to the network device — 203

FIG. 2

---

generating a temporal self-information image He by inputting the temporal CSI image Hc into a self-information domain transformer, a time dimension of both the temporal CSI image Hc and the temporal self-information image He is T — 301

generating a structural feature matrix and a temporal correlation matrix by inputting the temporal self-information image He into a temporal feature coupling encoder for feature extraction — 302

generating the feature codeword according to the structural feature matrix and the temporal correlation matrix — 303

FIG. 3

obtaining a first temporal feature image F by inputting the temporal CSI image Hᴄ into a three-dimensional convolutional feature extraction network for feature extraction ⟋ 401

generating a first index matrix M according to the temporal CSI image Hᴄ ⟋ 402

obtaining the temporal self-information image Hₑ according to the first temporal feature image F and the first index matrix M ⟋ 403

FIG. 4

generating self-information of an area to be estimated in the temporal CSI image Hᴄ as a self-information image by inputting the temporal CSI image Hᴄ into a self-information module ⟋ 501

obtaining the first index matrix M by inputting the self-information image into an index matrix module for mapping ⟋ 502

FIG. 5

obtaining split images at a plurality of time points by splitting the temporal CSI image according to a time sequence ⟋ 601

dividing the split images into a plurality of areas to be estimated , obtaining self-information estimation values corresponding to the plurality of areas to be estimated, and generating a self-information image according to the self-information estimation values ⟋ 602

FIG. 6

obtaining a first information feature image by inputting the self-information image into the mapping network for feature extraction, wherein the mapping network is a two-dimensional convolutional neural network — 701

obtaining a second index matrix by inputting the first information feature image into the judger for binarization — 702

obtaining the first index matrix M by splicing the second index matrix — 703

FIG. 7

obtaining a first feature image by inputting the self-information image into the two-dimensional convolutional layer for feature extraction — 801

obtaining a second feature image by inputting the first feature image into the two-dimensional normalization layer to normalize pixel values in the first feature image — 802

obtaining the first information feature image by inputting the second feature image into the activation function layer for nonlinear mapping — 803

FIG. 8

obtaining a second information feature image by multiplying the first temporal feature image F and the first index matrix M — 901

generating the temporal self-information image by inputting the second information feature image into a dimension restoration network for dimension restoration — 902

FIG. 9

obtaining the temporal correlation matrix by inputting the temporal self-information image subjected to dimension transformation into a coupling LSTM for feature extraction ⌐1001

coupling the structural feature matrix and the temporal correlation matrix to generate the feature codeword ⌐1002

FIG. 10

obtaining a training temporal self-information image by inputting a training temporal CSI image into a self-information domain transformer ⌐1101

obtaining a training feature codeword by inputting the training temporal self-information image into a temporal feature coupling encoder ⌐1102

FIG. 11

receiving a feature codeword sent by a terminal ⌐1201

restoring the feature codeword to obtain a restored temporal CSI image ⌐1202

obtaining an estimated CSI image of the terminal according to the restored temporal CSI image ⌐1203

FIG. 12

obtaining a restored temporal self-information image by inputting the feature codeword into the decoupling module for decoupling ⌐1301

obtaining the restored temporal CSI image by inputting the restored temporal self-information image into the restoration convolutional neural network for restoration ⌐1302

FIG. 13

obtaining a restored structural feature matrix by inputting the feature codeword into the one-dimensional time-space decompression network for decompression ⌐1401

obtaining a restored temporal correlation matrix by inputting the feature codeword into the decoupling LSTM for decoupling ⌐1402

obtaining the restored temporal self-information image according to the restored structural feature matrix and the restored temporal correlation matrix ⌐1403

FIG. 14

receiving training data sent by the terminal, wherein the training data comprises a training feature codeword, a time-sequence length of a temporal self-information image , a dimension of the training feature codeword, and a training temporal CSI image ⌐1501

obtaining a restored temporal CSI image according to the training feature codeword ⌐1502

performing training according to the restored temporal CSI image and the training temporal CSI image ⌐1503

FIG. 15

determining a number of structural units in a decoupling LSTM according to the time-sequence length of the temporal self-information image ⎯1601

determining network parameters of a one-dimensional time-space decompression network according to the dimension of the training feature codeword ⎯1602

FIG. 16

⎯ 170

communication device

transceiver module ⎯1701

processing module ⎯1702

FIG. 17

180

processor ⎯1801

memory ⎯1802

computer program ⎯1803

interface circuit ⎯1806

transceiver ⎯1804

antenna ⎯1805

FIG. 18

FIG. 19

# EP 4 451 575 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **YANG XU et al.** Transformer Empowered CSI Feedback for Massive MIMO Systems. *30th Wireless and optical communications conference*, 2021
- **CHAO LU et al.** MIMO Channel Information Feedback Using Deep Recurrent Network. *IEEE Communication letters*, 2019
- **QI LI et al.** A Novel CSI Feedback Approach for Massive MIMO Using LSTM-Attention CNN. *IEEE access*, 2020